(19) Europäisches Patentamt / European Patent Office / Office européen des brevets

(11) **EP 4 095 573 A1**

(12) **EUROPEAN PATENT APPLICATION**

(43) Date of publication:
**30.11.2022  Bulletin 2022/48**

(21) Application number: **21176240.6**

(22) Date of filing: **27.05.2021**

(51) International Patent Classification (IPC):
**G02B 5/18** (2006.01)      **G03F 7/20** (2006.01)

(52) Cooperative Patent Classification (CPC):
**G02B 5/1838; G03F 7/706**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **CHONG, Derick, Yun, Chek
5500 AH Veldhoven (NL)**

• **REDDY, Bogathi, Vishnu, Vardhana
5500 AH Veldhoven (NL)**
• **ENGELEN, Wouter, Joep
5500 AH Veldhoven (NL)**
• **DE GROOT, Pieter, Cristiaan
5500 AH Veldhoven (NL)**

(74) Representative: **ASML Netherlands B.V.
Corporate Intellectual Property
P.O. Box 324
5500 AH Veldhoven (NL)**

(54)   **DIFFRACTION GRATING FOR MEASUREMENTS IN EUV-EXPOSURE APPARATUSES**

(57)    Diffraction gratings for a phase-stepping measurement system for determining an aberration map for a projection system are disclosed. The gratings are two-dimensional diffraction gratings for use as wafer level gratings in an EUV lithographic apparatus. In particular, the diffraction gratings comprise a substrate provided with a two-dimensional array of circular through-apertures (51) and are self-supporting. In some embodiments, a ratio of the radius of the circular apertures to the distance between the centres of adjacent apertures may be selected to minimize the gain and cross-talk errors of a wavefront reconstruction algorithm. For example, the ratio may be between 0,34 and 0,38. In some embodiments, the circular apertures are distributed such that a distance between the centres of adjacent apertures is non-uniform and varies across the diffraction grating. For example, a local pitch of the grating may vary randomly across the diffraction grating.

FIG. 12

**Description**

FIELD

The present invention relates to diffraction gratings for a phase-stepping measurement system for determining an aberration map for a projection system and to methods for designing such a diffraction grating. In particular, the present invention relates to a two-dimensional diffraction grating for a shearing phase-stepping interferometric measurement system formed by an array of circular apertures, or pinholes, in a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Radiation that has been patterned by the patterning device is focussed onto the substrate using a projection system. The projection system may introduce optical aberrations, which cause the image formed on the substrate to deviate from a desired image (for example a diffraction limited image of the patterning device).

It may be desirable to provide methods and apparatus for accurately determining such aberrations caused by a projection system such that these aberrations can be better controlled.

SUMMARY

According to a first aspect of the present disclosure, there is provided a diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is between 0.34 and 0.38.

A measurement system for determining an aberration map for a projection system may be used to measure aberrations caused by the projection system. Such a measurement system may be used within a lithographic apparatus and may comprise a shearing interferometer. The measurement system typically uses a patterning device at reticle level (i.e. disposed in an object plane of the lithographic apparatus) and a sensor at wafer level (i.e. disposed in an image plane of the lithographic apparatus). The reticle level patterning device may, for example, comprise a diffraction grating. The wafer level sensor comprises a second patterning device (for example a two dimensional diffraction grating) and a radiation detector (for example an array of sensing elements). The reticle level patterning device is illuminated with radiation to form a plurality of first diffraction beams, the first diffraction beams being separated in a shearing direction. The projection system at least partially captures the plurality of first diffraction beams and images these onto the patterning device of the wafer level sensor. The second patterning device receives the first diffraction beams from the projection system and forms a plurality of second diffraction beams from each of the first diffraction beams, which are incident on the radiation detector.

The pitches of the first and second patterning devices are matched in a shearing direction, taking into account any reduction factor applied by the projection system, such that the pitch of the second patterned region (which may be in accordance with the first aspect) in said shearing direction is an integer multiple of the pitch of the first patterned region in said shearing direction or, alternatively, the pitch of the first patterned region in said shearing direction should be an integer multiple of the pitch of the second patterned region in said shearing direction.

At least one of the reticle level patterning device and the wafer level sensor apparatus is scanned or stepped in the shearing direction such that an intensity of radiation received by each part of the radiation detector varies as a function of this movement in the shearing direction so as to form an oscillating signal. A phase of a harmonic (for example the first harmonic) of the oscillating signal at a plurality of positions on the radiation detector (for example at each sensing element) is determined. Form these, a set of Zernike coefficients that characterize the aberration map of the projection system are determined.

In general, there will be a plurality of different contributions to the harmonic of the oscillating signal at the radiation detector, each having a different overlay with the detector (i.e. coinciding with a different set of sensing elements) and, in general, having a different intensity. In (transmissive) deep ultraviolet (DUV) lithographic apparatus, one known arrangement uses a one dimensional diffraction grating for the patterning device at reticle level with a duty cycle of 50% and a checkerboard grating for the patterning device at wafer level. With such an arrangement, across most of the radiation detector the first harmonic of the oscillating (phase-stepping) signal at the radiation detector receives only two contributions which have the same intensity. This simplifies the reconstruction of the aberration map significantly.

However, a true checkerboard grating requires a transmissive support layer, which is unsuitable for use in extreme ultraviolet (EUV) lithographic systems since (a) EUV radiation is strongly absorbed by most materials and (b) such a transmissive carrier will rapidly become contaminated in a wafer production environment of an EUV lithographic system, which would render the transmissive carrier untransmissive for EUV. For the above-mentioned reasons a checkerboard grating arrangement is difficult to implement for lithographic systems that use EUV radiation and existing arrangements typically use a pinhole array at wafer level in place of a checkerboard grating. Since a checkerboard grating has a duty cycle of 50% (by area), the sizes of the pinholes are typically chosen such that the pinhole array also has a duty cycle of 50% (by area). This is achieved by selecting a ratio of the radius of the circular apertures to the distance between the centres of adjacent apertures of -0.4.

It is known that the use of a pinhole array geometry for the wafer level patterning device generates unwanted interference beams that contribute to the first harmonic of the phase stepping signal. In particular, in addition to the two contributions that are present with a checkerboard grating, there are a large number of additional interference beams with small, but non-zero, intensities at the radiation detector. Furthermore, each of these contributions has a different overlap with the radiation detector, for example with a circular portion of the radiation detector that corresponds to the numerical aperture of the projection system.

The intensities of the additional interference beams that contribute to the first harmonic of the oscillating (phase-stepping) signal are small (in comparison to the intensities of the two contributions present when a checkerboard is used). Therefore, a first type of known aberration measurement system for EUV radiation neglects these terms (i.e. assumes that they are zero) in the reconstruction of the wavefront to find the set of Zernike coefficients. This assumption impacts the accuracy of the wavefront measurement. In turn, this has a negative impact on system imaging, overlay and focus performance of the lithographic apparatus. Embodiments of the present invention have been devised to at least partially address the above-described problems for aberration measurement systems for EUV radiation.

One solution that has been proposed to address the problems caused by the presence of additional contributions to the first harmonic of the oscillating (phase-stepping) signal is to use a two-dimensional diffraction grating at wafer level that has a geometry that reduces the total number of interference beams that contribute significantly to the first harmonic of the phase stepping signal.

In a first example, it was suggested that an array of square apertures be used (with the axes of the array rotated relative to the shearing direction by an angle of 45°). In particular, it was previously taught that each of the square apertures should have a length that is half the distance between the centres of adjacent apertures. It was found that such an arrangement was particularly beneficial since it could provide a self-supporting grating that resulted in only four contributions to the first harmonic of the phase stepping signal, all having an equal intensity.

In the alternative, it was proposed that the diameter and the spacing of the apertures of a pinhole array be selected so as to reduce the total number of interference beams that contribute significantly (for example with an interference strength above a threshold value) to the first harmonic of the phase stepping signal. For example, in one known solution to the above problem, it was proposed that rather than selecting a ratio of the radius of the circular apertures to the distance between the centres of adjacent apertures of -0.4 (to achieve a duty cycle of 50% by area), the ratio of the radius of the circular apertures to the distance between the centres of adjacent apertures should be selected to be either 0.3 or 0.43. In a first example, a grating wherein the ratio of the radius of the apertures to the distance between the centres of adjacent apertures is approximately 0.3 was selected to suppress, or minimise, the (±2, 0) and (0,±2) diffraction orders of the pinhole grating (which are both zero for a perfect checkerboard grating). It was found that this ratio was beneficial for the reconstruction of the aberration map (relative to the nominal value of -0.4). In a second example, a grating wherein the ratio of the radius of the apertures to the distance between the centres of adjacent apertures is approximately 0.43 was selected to suppress, or minimise, the (±1, ±1) diffraction orders (which are zero for a perfect checkerboard grating). Again, it was found that this ratio was beneficial for the reconstruction of the aberration map (relative to the nominal value of -0.4).

However, contrary to these teachings, the inventors of the present invention have found that better pinhole geometries can be selected. In particular, although it is desirable to reduce the number of contributions to the first harmonic of the phase stepping signal, the inventors have found that it is better to select a geometry of the wafer level grating based on the gain and cross-talk errors of the reconstruction algorithm, as now discussed.

The inventors have realised that the errors in the aberration map reconstruction can be better controlled in the following way. A wavefront aberration map represents the distortions of the wavefront of light approaching a point in an image plane of the projection system from a spherical wavefront and can be expressed as a linear combination of Zernike polynomials. It is possible to input a pure Zernike wavefront aberration map (for example $Z_n$) into a reconstruction algorithm and to assess how the reconstruction algorithm reconstructs this as a linear combination of Zernike polynomials.

Ideally, the reconstruction algorithm should output a set of Zernike coefficients $c_m$ such that $c_m = 1$ for $m = n$ and $c_m = 0$ for $m \neq n$. Any variation of $c_n$ from 1 may be referred to as a gain error. Furthermore, any variation of $c_m$ from 0 where $m \neq n$ may be referred to as a cross-talk error.

It has been found from a 2 dimensional simulation that for an aberration map measurement system using a one dimensional diffraction grating at reticle level with a duty cycle of 50% and a pinhole array grating at wafer level that a global reduction in the gain errors and the cross-talk errors of the order of a factor of 2 may be obtained using a ratio of the radius of the circular pinhole apertures to the distance between the centres of adjacent apertures of around 0.36, relative to the nominal value of 0.4. Furthermore, it has been found from this 2 dimensional simulation that a global reduction in the gain errors and the cross-talk errors is also achieved relative to the previously suggested optimised value of 0.3.

It is believed that as the ratio of the radius of the circular pinhole apertures to the distance between the centres of adjacent apertures is reduced from the nominal value of 0.4 the gain errors and the cross-talk errors reduce up to a point and thereafter the gain errors and the cross-talk errors start to increase again as this ratio tends to the previously proposed value of 0.3.

Therefore, it is believed that in the range of 0.34 to 0.38 a reduction in the gain errors and the cross-talk errors is achieved relative to the two previously disclosed values of 0.3 and 0.4.

The optimization of the value of the ratio of the radius of the circular pinhole apertures to the distance between the centres of adjacent apertures is difficult for two reasons.

First, the actual error in a reconstructed aberration map is dependent on both the errors (i.e. the gain errors and the cross-talk errors) and the aberrations experienced by the projection system being analysed. For example, for a projection system that is prone to relatively large $Z_i$ aberrations and relatively low $Z_j$ aberrations may in practice perform better using a ratio of the radius of the circular pinhole apertures to the distance between the centres of adjacent apertures that minimise the gain errors and the cross-talk errors for $Z_i$ aberrations, even if there is an increase in the gain errors and the cross-talk errors for $Z_j$ aberrations.

Second, the simulation should take into account the fact that the diffraction grating is three-dimensional, which means that the grating will not be a perfect binary grating. For example, due to the finite, non-zero thickness of the grating, radiation incident on substrate in-between the apertures will, in general, not be perfectly absorbed. In addition, in use, radiation may be incident on the grating at a range of angles. As a result, at least some of the radiation that is incident on the membrane (for example at a large angle of incidence and close to one of the through apertures) will propagate through a distance in the membrane that is only a small fraction of the thickness of the membrane and will therefore not be fully attenuated. Furthermore, in general, there may be a difference in refractive index between the substrate and the surrounding medium (which will be in the through-apertures). As a result, there will be a phase difference induced between the radiation that propagates through the membrane and the radiation that does not (due to the different optical path lengths experienced).

It is thought that taking into account such 3 dimensional effects, there may be a small shift in the optimum ratio of the radius of the circular pinhole apertures to the distance between the centres of adjacent apertures of around, which may be dependent on the optical properties of the material from which the grating is formed and the thickness of the membrane. However, it is thought that this optimum ratio will lie in the range of 0.34 to 0.38.

The ratio of the radius of the circular apertures to the distance between the centres of adjacent apertures may be between 0.35 and 0.37.

The ratio of the radius of the circular apertures to the distance between the centres of adjacent apertures may be approximately 0.36.

The ratio of the radius of the circular apertures to the distance between the centres of adjacent apertures may be close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

The ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

According to a second aspect of the present disclosure, there is provided a diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

According to a third aspect of the present disclosure, there is provided a diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

The measurement plane may correspond to a position of a radiation detector of the phase-stepping measurement system.

When a checkerboard grating is used as the wafer level patterning device of a phase-stepping measurement system for determining an aberration map, the interference beam map in a region that corresponds to an overlap in a measurement plane between the first and second diffraction beams (that result from the $0^{th}$ order diffraction beam from the reticle level patterning device illuminating the diffraction grating) is uniform. This is because across the whole of this region of the measurement plane there are exactly two diffraction beams which contribute to the first harmonic of the oscillating phase-stepping signal and these have equal interference strengths.

However, when a pinhole array geometry is used for the wafer level patterning device this generates unwanted interference beams that contribute to the first harmonic of the phase stepping signal. In particular, in addition to the two contributions that are present with a checkerboard grating, there are a large number of additional interference beams with small, but non-zero, intensities at the radiation detector. Since each of these contributions has a different position in the measurement plane there will, in general, be some variation in the interference beam map (since different positions will, in general, have different contributions to the first harmonic of the oscillating phase-stepping signal).

In general, the first harmonic of the oscillating phase-stepping signal only depends on the contributions from first diffraction beams (i.e. diffraction beams formed by the reticle level patterning device) that differ in order by $\pm1$. With a reticle level patterning device that comprises a one-dimensional diffraction grating with a 50% duty cycle the only two pairs of first diffraction beams that differ in order by $\pm1$ are the $0^{th}$ order beam with either the $\pm1^{st}$ order beams.

Each interference beam may represent a plurality of interfering second interference beams formed by the diffraction grating. Each such interference beam may be considered to propagate in a different direction, such that the projection of each interference beam onto the measurement plane is different.

The interference strengths for such interference beams that contribute to the first harmonic of the oscillating phase-stepping signal can be determined as follows.

First, a scattering efficiency plot of the diffraction grating is determined. Next, a second copy of this scattering efficiency plot for the diffraction grating is weighted by the scattering efficiency for the $\pm1^{st}$ order diffraction beams of the reticle level patterning device and then overlaid with the scattering efficiency plot for the diffraction grating but shifted in the shearing direction by the separation of 1 pair of diffraction orders (of the reticle level patterning device). Where the pitches of the reticle level and wafer level patterning devices in the shearing direction are equal (taking into account any reduction factor applied by the projection system), the second copy of the scattering efficiency plot for the diffraction grating is a shifted in the shearing direction by 1 diffraction order of the diffraction grating. The product of the scattering efficiencies of these two overlaid scattering efficiencies plots is then determined. This gives the interference strengths for all interference beams.

According to a fourth aspect of the present disclosure, there is provided a diffraction grating for a phase-stepping measurement system for determining an aberration map for a projection system, the diffraction grating comprising a substrate provided with a two-dimensional array of circular through-apertures, wherein the circular through-apertures are distributed such that a distance between the centres of adjacent apertures is non-uniform and varies across the diffraction grating.

Typically, a diffraction grating comprises a plurality of apertures that are distributed such that a distance between the centres of adjacent apertures is uniform across the diffraction grating. This is achieved by arranging the apertures such that a centre of each of the circular through-apertures coincides with one of a square array of positions. In contrast, the diffraction grating according to the fourth aspect is formed by arranging the apertures such that a centre of each of the circular through-apertures is proximate to one of a square array of positions and is offset from said one of a square array of positions by an amount which varies across the diffraction grating.

A distance between the centres of adjacent apertures may be referred to as the local pitch of the diffraction grating. The inventors have realised that by introducing local pitch variation, the diffraction grating according to the fourth aspect alters the diffraction pattern. In particular, the inventors have realised that such local pitch variation supresses higher order diffraction beams more than lower order diffraction beams. In turn, advantageously, this reduces the effect of the influence of the additional interference beams that contribute to the first harmonic of the phase stepping signal that are not present when a two-dimensional checkerboard grating is used.

It has been found from a simulation that for an aberration map measurement system using a one dimensional diffraction grating at reticle level with a duty cycle of 50% and a pinhole array grating at wafer level that a global reduction in the gain errors and the cross-talk errors of the order of a factor of 2 may be obtained using a randomized pitch variation across the grating.

The variation in the distance between the centres of adjacent apertures across the diffraction grating may be random or pseudo-random.

The variation in the distance between the centres of adjacent apertures across the diffraction grating may be between a nominal distance $\pm$ less than 10 %.

The variation in the distance between the centres of adjacent apertures across the diffraction grating may be between a nominal distance $\pm$ 5 %.

That is, the local pitch may vary between 95% and 105% of a nominal pitch.

A distribution of the distance between the centres of adjacent apertures across the diffraction grating may be generally uniform between a lower value and a higher value.

For example, for a random variation in the distance between the centres of adjacent apertures across the diffraction grating is between a nominal distance $\pm$ 5 %, the lower value may be 95% of a nominal pitch and the higher value may be 105% of a nominal pitch.

A distribution of an offset of each of the apertures from a nominal position may be generally uniform between a lower value and a higher value.

The distribution of the offset of each of the apertures from a nominal position in a direction of an axis of the diffraction grating may be generally uniform between a lower value and a higher value.

For example, the apertures may be arranged such that a centre of each of the circular through-apertures is proximate to one of a square array of positions and is offset from said one of a square array of positions by an amount which varies across the diffraction grating. The axes of the diffraction grating may be the axes of said square array of positions. The axes of the diffraction grating may be referred to as the x direction and the y direction.

The distribution of offsets $\Delta x$ from the nominal position in an x direction may be uniform and distribution of offsets $\Delta y$ from the nominal position in an y direction may be uniform. Alternatively, a distribution of a total offset $\Delta r$ from the nominal position may be uniform.

Alternatively, the offsets of the apertures from a nominal position may have any other distribution.

A ratio of the radius of the circular apertures to the distance between the centres of adjacent apertures may be between 0.34 and 0.38.

A ratio of the radius of the circular apertures to the distance between the centres of adjacent apertures may be between 0.35 and 0.37.

The ratio of the radius of the circular apertures to the distance between the centres of adjacent apertures may be approximately 0.36.

The ratio of the radius of the circular apertures to the distance between the centres of adjacent apertures may be close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

The ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

The diffraction grating may be self-supporting.

In use, the diffraction grating may be provided with a support for the absorbing layer. The support may only contact a peripheral portion of the absorbing layer. That is, the support may be of the form of a frame and which does is not adjacent to a central portion of the absorbing layer. With such an arrangement, in a central portion of the absorbing layer, the absorbing layer may be considered to be self-supporting. To achieve this, the absorbing layer may be tensioned on the support (for example such that it remains generally planar).

Advantageously, for embodiments wherein the central portion of the absorbing layer is self-supporting, the grating does not need, for example, a transmissive supporting layer. Such an arrangement is particularly beneficial for use in a phase-stepping measurement system for determining an aberration map for a projection system that uses EUV radiation since the use of such a transmissive supporting layer would significantly reduce the amount of EUV radiation that is transmitted by the diffraction grating.

The substrate may comprise a radiation absorbing layer.

The radiation absorbing layer may, for example, be formed from a metal such as, for example, chromium (Cr), nickel (Ni), cobalt (Co) or aluminium (Al).

In some embodiments, the absorbing layer may comprise a ceramic. The ceramic may comprise a metal or metalloid component having a relatively high extinction coefficient for EUV radiation and a non-metal component. Both components may have a refractive index for EUV which is relatively close to 1. The ceramic may comprise aluminium nitride (AlN). In some embodiments, the absorbing layer may comprise aluminium nitride (AlN).

The substrate may further comprise a support layer; and the through-apertures may extend through both the support layer and the radiation absorbing layer.

The support layer may, for example, be formed from SiN.

According to a fifth aspect of the present disclosure, there is provided a method of designing a diffraction grating for a phase-stepping measurement system for determining an aberration map for a projection system, the diffraction grating comprising a substrate provided with a two-dimensional array of circular through-apertures, the method comprising: selecting a value of a ratio of the radius of the circular apertures to the distance between the centres of adjacent apertures that substantially minimises errors in a reconstruction of the aberration map.

The ratio of the radius of the circular apertures to the distance between the centres of adjacent apertures may be selected so as to substantially minimize gain and cross-talk errors when the diffraction grating is used as a wafer level patterning device of a phase-stepping measurement system for determining an aberration map for a projection system and wherein a reconstruction algorithm of the phase-stepping measurement system assumes that the grating is of the form of a checkerboard grating.

Optionally, the selection so as to substantially minimize gain and cross-talk errors when the diffraction grating is used as a wafer level patterning device of a phase-stepping measurement system for determining an aberration map for a projection system is for the case where the diffraction gratin is used in combination with a reticle level patterning device that comprises a one-dimensional diffraction grating with a 50% duty cycle.

The ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system for zero aberrations; and wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

Optionally, the selection so as to substantially minimize a variation in an interference beam map when the diffraction grating is used as a wafer level patterning device of a phase-stepping measurement system for determining an aberration map for a projection system is for the case where the diffraction gratin is used in combination with a reticle level patterning device that comprises a one-dimensional diffraction grating with a 50% duty cycle.

According to a sixth aspect of the present disclosure, there is provided a method of designing a diffraction grating for a phase-stepping measurement system for determining an aberration map for a projection system, the diffraction grating comprising a substrate provided with a two-dimensional array of circular through-apertures, the method comprising: selecting a square array of positions on a membrane; and selecting a position for an aperture proximate to each one of the square array of positions but offset therefrom; wherein selecting the position for an aperture comprises generating a first random or pseudo-random number $N_x$ between $\pm|x_{max}|$ and a second random or pseudo-random number $N_y$ between $\pm|y_{max}|$ and wherein the position of the aperture is selected such that a centre of the aperture is offset from the proximate position in the square array by a distance of $N_x$ parallel to a first one of the axes of the square array and by a distance of $N_y$ parallel to a first one of the axes of the square array.

According to a seventh aspect of the present disclosure, there is provided a diffraction grating designed according to a method according to the fifth aspect of the present disclosure or a method according to the sixth aspect of the present disclosure.

According to an eighth aspect of the present disclosure, there is provided a measurement system for determining an aberration map for a projection system, the measurement system comprising: a patterning device; an illumination system arranged to illuminate the patterning device with radiation, the patterning device comprising a first patterned region arranged to receive a radiation beam and to form a plurality of first diffraction beams, the first diffraction beams being separated in a shearing direction; a sensor apparatus comprising a second patterned region, the second patterned region comprising a two-dimensional diffraction grating according to any one of the first, second, third, fourth or seventh aspects of the present disclosure, and a radiation detector; the projection system being configured to project the first diffraction beams onto the sensor apparatus, the second patterned region being arranged to receive the first diffraction beams from the projection system and to form a plurality of second diffraction beams from each of the first diffraction beams; a positioning apparatus configured to move at least one of the patterning device and the sensor apparatus in the shearing direction; and a controller configured to: control the positioning apparatus so as to move at least one of the first patterning device and the sensor apparatus in the shearing direction such that an intensity of radiation received by each part of the radiation detector varies as a function of the movement in the shearing direction so as to form an oscillating signal; determine from the radiation detector a phase of a harmonic of the oscillating signal at a plurality of positions on the radiation detector; and determine a set of coefficients that characterize the aberration map of the projection system from the phase of a harmonic of the oscillating signal at the plurality of positions on the radiation detector.

The measurement system according to the eighth aspect of the invention is advantageous, particularly for a projection system that uses EUV radiation because the two-dimensional diffraction grating can be self-supporting whilst providing better control the contributions to a harmonic (for example the first harmonic) of a phase stepping signal.

Therefore, the measurement system according to the eighth aspect of the invention can provide a measurement system for determining aberrations for an EUV projection system which can provide better control over contributions to the first harmonic of the phase stepping signal. In turn, this can reduce errors in the determined set of coefficients that characterize the aberration map of the projection system.

According to a ninth aspect of the present disclosure, there is provided a lithographic apparatus comprising the measurement system according to the eighth aspect of the present disclosure.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 is a schematic illustration of a measurement system according to an embodiment of the invention;
- Figures 3A and 3B are schematic illustrations of a patterning device and a sensor apparatus which may form part of the measurement system of Figure 2;
- Figure 4 is a schematic illustration of a measurement system according to an embodiment of the invention, the measurement system comprising a first patterned region and a second patterned region, the first patterned region arranged to receive
radiation and to form a plurality of first diffraction beams;
- Figures 5A to 5C each shows a different set of second diffraction beams formed by the second patterned region of the measurement system shown in Figure 4, that set of second diffraction beams having been produced by a different first diffraction beam formed by the first patterned region;
- Figure 6A shows the scattering efficiency for one dimensional diffraction grating with a 50% duty cycle and which may represent the first patterned region of the measurement system shown in Figure 4;
- Figure 6B shows the scattering efficiency for two dimensional diffraction grating of the form of a checkerboard with a 50% duty cycle and which may represent the second patterned region of the measurement system shown in Figure 4;

- Figure 6C shows an interference strength map for the measurement system shown in Figure 4 when employing the first patterned region shown in Figure 6A and the second patterned region shown in Figure 6B, each of the interference strengths shown representing the second interference beams which contribute to the first harmonic of the oscillating phase-stepping signal and which have a different overlap, at the radiation detector, with a circle that represents the numerical aperture of the projection system PS;

- Figures 7A, 7B and 7C show the portion of the numerical aperture of the projection system of the measurement system shown in Figure 4 that is filled by the three different first diffraction beams shown in Figure 4;

- Figures 8A-8C show a portion of the radiation detector of the measurement system shown in Figure 4 which corresponds to the numerical aperture of the projection system of the measurement system and which is filled by three second diffraction beams which originate from the first diffraction beam represented by Figure 7B;

- Figures 9A-9C show a portion of the radiation detector of the measurement system shown in Figure 4 which corresponds to the numerical aperture of the projection system of the measurement system and which is filled by three second diffraction beams which originate from the first diffraction beam represented by Figure 7A;

- Figures 10A-10C show a portion of the radiation detector of the measurement system shown in Figure 4 which corresponds to the numerical aperture of the projection system of the measurement system and which is filled by three second diffraction beams which originate from the first diffraction beam represented by Figure 7C;

- Figure 11A show a portion of the radiation detector of the measurement system shown in Figure 4 which corresponds to the numerical aperture of the projection system of the measurement system and which represents the overlap between the second diffraction beams shown in Figures 8B and 9A and the overlap between the second diffraction beams shown in Figures 8A and 10B;

- Figure 11B show a portion of the radiation detector of the measurement system shown in Figure 4 which corresponds to the numerical aperture of the projection system of the measurement system and which represents the overlap between the second diffraction beams shown in Figures 8B and 10C and the overlap between the second diffraction beams shown in Figures 8C and 9B;

- Figure 12 shows a unit cell of a grating comprising an array of circular pinholes and having a 50% (by area) duty cycle;

- Figure 13A shows the scattering efficiency for one dimensional diffraction grating with a 50% duty cycle and which may represent the first patterned region of the measurement system shown in Figure 4;

- Figure 13B shows the scattering efficiency for two dimensional diffraction comprising the unit cell of Figure 12 and which may represent the second patterned region of the measurement system shown in Figure 4;

- Figure 13C shows an interference strength map for the measurement system shown in Figure 4 when employing the first patterned region shown in Figure 13A and the second patterned region shown in Figure 13B, each of the interference strengths shown representing the second interference beams which contribute to the first harmonic of the oscillating phase-stepping signal and which have a different overlap, at the radiation detector, with a circle that represents the numerical aperture of the projection system;

- Figure 14A is a representation of 21 second diffraction beams generated by a second patterned region having a unit cell as shown in Figure 12, the second diffraction beams corresponding to diffraction efficiencies contained within the white dotted line in Figure 13B;

- Figure 14B is a representation of 16 interference beams, each generated by the interference of pairs of the second diffraction beams shown in Figure 14A, each of the interference beam corresponding to an interference strength contained within the white dotted line in Figure 13C;

- Figures 15A to 15D show plots of the elements of an error matrix; Figures 15A and 15B show the error matrix for gratings having a pitch of 255 nm whereas 15C and 15D show the error matrix for gratings having a pitch of 1414 nm; Figures 15A and 15C represent the error matrix for a checkerboard grating whereas Figures 15B and 15D represent the error matrix for a pinhole grating having a nominal ratio of radius to pitch of -0.4;

- Figures 16A to 16D show plots of the elements of an error matrix for gratings having a pitch of 255 nm, each of Figures 16A to 16D representing the error matrix for a pinhole grating having a different ratio of radius to pitch.

- Figures 17A to 17F show plots of the elements of an error matrix for gratings having a pitch of 1414 nm, each of Figures 17A to 17F representing the error matrix for a pinhole grating having a different ratio of radius to pitch.

- Figure 18 shows the gain errors (i.e. the diagonal elements of the error matrix) for the error matrices shown in Figures 17A to 17F.

- Figures 19A and 19B show plots of the elements of an error matrix for gratings having a pitch of 1414 nm; Figure 19A represents the error matrix for a pinhole grating having a nominal ratio of radius to pitch of ~0.4 and Figure 19B represents the error matrix for a pinhole grating having 0.9 times the nominal ratio of radius to pitch.

- Figures 20A to 20E each show an interference beam map for a different geometry of diffraction grating of the second patterned region of a measurement system for determining an aberration map for a projection system;

- Figures 21A and 21B schematically show the geometry of two different pinhole gratings; Figure 21A comprising a plurality of apertures that are distributed such that a distance between the centres of adjacent apertures is uniform across the diffraction grating; and Figure 21B comprising a plurality of apertures arranged such that a centre of each of the circular through-apertures is proximate to one of a square array of positions but is offset from said one of a square array of positions by an amount which varies across the diffraction grating;

- Figure 22 shows an example of a distribution of the distances between the centres of adjacent apertures across the diffraction grating shown in Figure 21B;

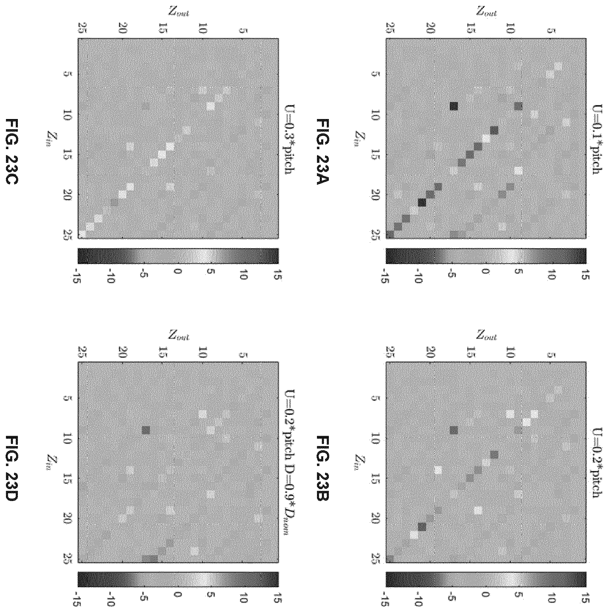

- Figures 23A to 23D show plots of the elements of an error matrix for gratings having a nominal pitch of 255 nm; each of Figures 23A to 23C represents the error matrix for a pinhole grating having a ratio of the radius of the apertures to a nominal distance between the centres of adjacent apertures equal to the nominal value of ~0.4 and having a different local pitch variation whereas Figure 23D represents the error matrix for a pinhole grating having a ratio of the radius of the apertures to a nominal distance between the centres of adjacent apertures equal to 0.9 the nominal value (i.e. -0.36) and having a local pitch variation of 0.1 times the nominal pitch; and

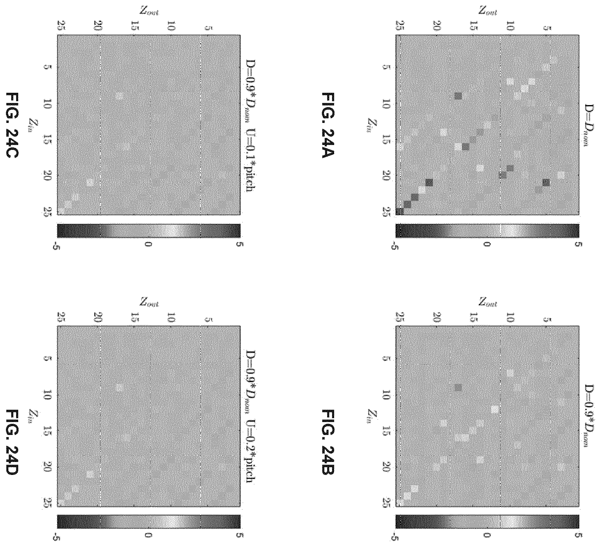

- Figures 24A to 24D show plots of the elements of an error matrix for gratings having a nominal pitch of 1414 nm; Figure 24A represents the error matrix for a pinhole grating having a ratio of the radius of the apertures to a nominal distance between the centres of adjacent apertures equal to the nominal value of ~0.4 and having a no local pitch variation; Figure 24B represents the error matrix for a pinhole grating having a ratio of the radius of the apertures to a nominal distance between the centres of adjacent apertures equal to 0.9 times the nominal value (i.e. a ratio of -0.36) and having a no local pitch variation; each of Figures 24C and 24D represents the error matrix for a pinhole grating having a ratio of the radius of the apertures to a nominal distance between the centres of adjacent apertures equal 0.9 times the nominal value (i.e. a ratio of -0.36) and having a different local pitch variation .

<u>DETAILED DESCRIPTION</u>

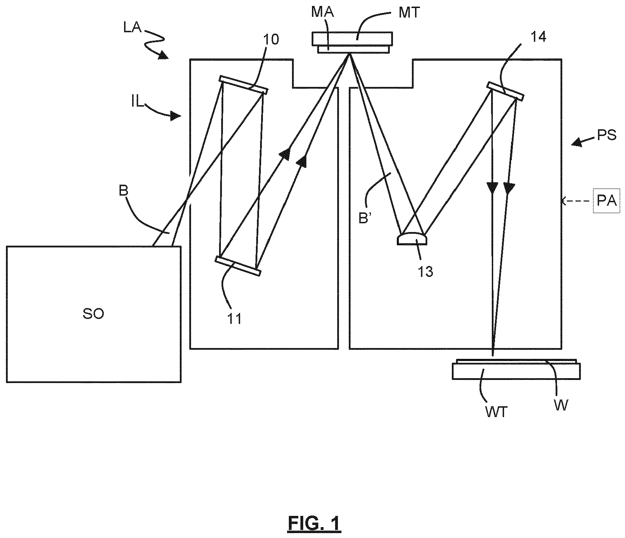

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B' thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In general, the projection system PS has an optical transfer function which may be non-uniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be obtained from a measured scalar map by calculating the inner product of the measured scalar map with each Zernike polynomial in turn and dividing this by the square of the norm of that Zernike polynomial. In the following, unless stated otherwise, any reference to Zernike coefficients will be understood to mean the Zernike coefficients of a relative phase map (also referred to herein as an aberration map). It will be appreciated that in alternative embodiments other sets of basis functions may be used. For example some embodiments may use Tatian Zernike polynomials, for example for obscured aperture systems.

The wavefront aberration map represents the distortions of the wavefront of light approaching a point in an image plane of the projection system PS from a spherical wavefront (as a function of position in the pupil plane or, alternatively, the angle at which radiation approaches the image plane of the projection system PS). As discussed, this wavefront aberration map $W(x, y)$ may be expressed as a linear combination of Zernike polynomials:

$$W(x,y) = \sum_n c_n \cdot Z_n(x,y) \tag{1}$$

where x and y are coordinates in the pupil plane, $Z_n(x, y)$ is the nth Zernike polynomial and $c_n$ is a coefficient. It will be appreciated that in the following, Zernike polynomials and coefficients are labelled with an index which is commonly referred to as a Noll index. Therefore, $Z_n(x, y)$ is the Zernike polynomial having a Noll index of n and $c_n$ is a coefficient having a Noll index of n. The wavefront aberration map may then be characterized by the set of coefficients $c_n$ in such an expansion, which may be referred to as Zernike coefficients.

It will be appreciated that only a finite number of Zernike orders are taken into account. Different Zernike coefficients of the phase map may provide information about different forms of aberration which are caused by the projection system PS. The Zernike coefficient having a Noll index of 1 may be referred to as the first Zernike coefficient, the Zernike coefficient having a Noll index of 2 may be referred to as the second Zernike coefficient and so on.

The first Zernike coefficient relates to a mean value (which may be referred to as a piston) of a measured wavefront. The first Zernike coefficient may be irrelevant to the performance of the projection system PS and as such may not be determined using the methods described herein. The second Zernike coefficient relates to the tilt of a measured wavefront in the x-direction. The tilt of a wavefront in the x-direction is equivalent to a placement in the x-direction. The third Zernike coefficient relates to the tilt of a measured wavefront in the y-direction. The tilt of a wavefront in the y-direction is equivalent to a placement in the y-direction. The fourth Zernike coefficient relates to a defocus of a measured wavefront. The fourth Zernike coefficient is equivalent to a placement in the z-direction. Higher order Zernike coefficients relate to other forms of aberration which are caused by the projection system (e.g. astigmatism, coma, spherical aberrations and other effects).

Throughout this description the term "aberrations" should be intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more. Furthermore, any reference to an aberration map for a projection system may include all forms of deviation of a wavefront from a perfect spherical wavefront, including those due to image placement.

The transmission map and the relative phase map are field and system dependent. That is, in general, each projection system PS will have a different Zernike expansion for each field point (i.e. for each spatial location in its image plane).

As will be described in further detail below, the relative phase of the projection system PS in its pupil plane may be determined by projecting radiation from an object plane of the projection system PS (i.e. the plane of the patterning device MA), through the projection system PS and using a shearing interferometer to measure a wavefront (i.e. a locus of points with the same phase). The shearing interferometer may comprise a diffraction grating, for example a two dimensional diffraction grating, in an image plane of the projection system (i.e. the substrate table WT) and a detector arranged to detect an interference pattern in a plane that is conjugate to a pupil plane of the projection system PS.

The projection system PS comprises a plurality of optical elements (including mirrors 13, 14). As already explained, although the projection system PS is illustrated as having only two mirrors 13, 14 in Figure 1, the projection system PS may include a different number of mirrors (e.g. six or eight mirrors). The lithographic apparatus LA further comprises adjusting means PA for adjusting these optical elements so as to correct for aberrations (any type of phase variation across the pupil plane throughout the field). To achieve this, the adjusting means PA may be operable to manipulate optical elements within the projection system PS in one or more different ways. The projection system may have a co-ordinate system wherein its optical axis extends in the z direction (it will be appreciated that the direction of this z axis changes along the optical path through the projection system, for example at each mirror or optical element). The adjusting means PA may be operable to do any combination of the following: displace one or more optical elements; tilt one or more optical elements; and/or deform one or more optical elements. Displacement of optical elements may be in any direction (x, y, z or a combination thereof). Tilting of optical elements is typically out of a plane perpendicular to the optical axis, by rotating about axes in the x or y directions although a rotation about the z axis may be used for non-rotationally symmetric optical elements. Deformation of an optical element may be performed for example by using actuators to exert force on sides of the optical element and/or by using heating elements to heat selected regions of the optical element. In general, it may not be possible to adjust the projection system PS to correct for apodizations (transmission variation across the pupil plane). The transmission map of a projection system PS may be used when designing masks MAs for the lithographic apparatus LA.

In some embodiments, the adjusting means PA may be operable to move the support structure MT and/or the substrate table WT. The adjusting means PA may be operable to displace (in any of the x, y, z directions or a combination thereof) and/or tilt (by rotating about axes in the x or y directions) the support structure MT and/or the substrate table WT.

A projection system PS which forms part of a lithographic apparatus may periodically undergo a calibration process. For example, when a lithographic apparatus is manufactured in a factory the optical elements (e.g. mirrors) which form the projection system PS may be set up by performing an initial calibration process. After installation of a lithographic apparatus at a site at which the lithographic apparatus is to be used, the projection system PS may once again be calibrated. Further calibrations of the projection system PS may be performed at regular intervals. For example, under normal use the projections system PS may be calibrated every few months (e.g. every three months).

Calibrating a projection system PS may comprise passing radiation through the projection system PS and measuring the resultant projected radiation. Measurements of the projected radiation may be used to determine aberrations in the projected radiation which are caused by the projection system PS. Aberrations which are caused by the projection system PS may be determined using a measurement system. In response to the determined aberrations, the optical elements which form the projection system PS may be adjusted so as to correct for the aberrations which are caused by the projection system PS.

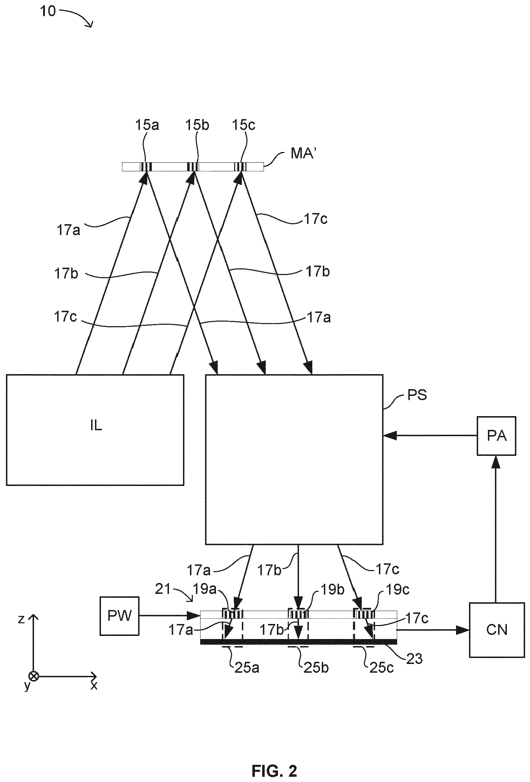

Figure 2 is a schematic illustration of a measurement system 10 which may be used to determine aberrations which are caused by a projection system PS. The measurement system 10 comprises an illumination system IL, a measurement patterning device MA', a sensor apparatus 21 and a controller CN. The measurement system 10 may form part of a lithographic apparatus. For example, the illumination system IL and the projection system PS which are shown in Figure 2 may be the illumination system IL and projection system PS of the lithographic apparatus which is shown in Figure 1. For ease of illustration additional components of a lithographic apparatus are not shown in Figure 2.

The measurement patterning device MA' is arranged to receive radiation from the illumination system IL. The sensor apparatus 21 is arranged to receive radiation from the projection system PS. During normal use of a lithographic apparatus, the measurement patterning device MA' and the sensor apparatus 21 which are shown in Figure 2 may be located in positions that are different to the positions in which they are shown in Figure 2. For example, during normal use of a lithographic apparatus a patterning device MA which is configured to form a pattern to be transferred to a substrate W may be positioned to receive radiation from the illumination system IL and a substrate W may be positioned to receive radiation from the projection system PS (as is shown, for example, in Figure 1). The measurement patterning device MA' and the sensor apparatus 21 may be moved into the positions in which they are shown in Figure 2 in order to determine aberrations which are caused by the projection system PS. The measurement patterning device MA' may be supported by a support structure MT, such as the support structure which is shown in Figure 1. The sensor apparatus 21 may be supported by a substrate table, such as the substrate table WT which is shown in Figure 1. Alternatively the sensor apparatus 21 may be supported by a measurement table (not shown) which may be separate to the sensor table WT.

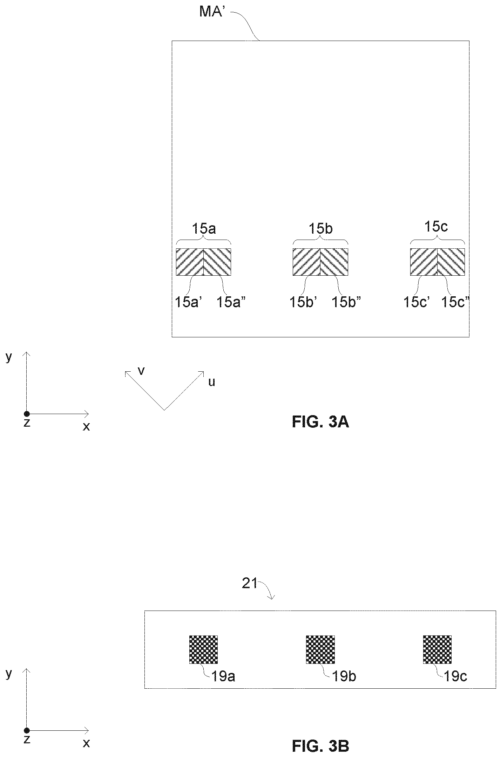

The measurement patterning device MA' and the sensor apparatus 21 are shown in more detail in Figures 3A and 3B. Cartesian co-ordinates are used consistently in Figures 2, 3A and 3B. Figure 3A is a schematic illustration of the measurement patterning device MA' in an x-y plane and Figure 3B is a schematic illustration of the sensor apparatus 21 in an x-y plane.

The measurement patterning device MA' comprises a plurality of patterned regions 15a-15c. In the embodiment which is shown in Figures 2 and 3A the measurement patterning device MA' is a reflective patterning device MA'. The patterned regions 15a-15c each comprises a reflective diffraction grating. Radiation which is incident on the patterned regions 15a-15c of the measurement patterning device MA' is at least partially scattered by thereby and received by the projection system PS. In contrast, radiation which is incident on the remainder of the measurement patterning device MA' is not reflected or scattered towards the projection system PS (for example, it may be absorbed by the measurement patterning device MA').

The illumination system IL illuminates the measurement patterning device MA' with radiation. Whilst not shown in Figure 2, the illumination system IL may receive radiation from a radiation source SO and condition the radiation so as to illuminate the measurement patterning device MA'. For example, the illumination system IL may condition the radiation so as to provide radiation having a desired spatial and angular distribution. In the embodiment which is shown in Figure 2, the illumination system IL is configured to form separate measurement beams 17a-17c. Each measurement beam 17a-17c illuminates a respective patterned region 15a-15c of the measurement patterning device MA'.

In order to perform a determination of aberrations which are caused by the projection system PL, a mode of the illumination system IL may be changed in order to illuminate the measurement patterning device MA' with separate measurement beams 17a-17c. For example, during normal operation of a lithographic apparatus, the illumination system IL may be configured to illuminate a patterning device MA with a slit of radiation. However the mode of the illumination system IL may be changed such that the illumination system IL is configured to form separate measurement beams 17a-17c in order to perform a determination of aberrations caused by the projection system PL. In some embodiments different patterned regions 15a-15c may be illuminated at different times. For example, a first subset of the patterned regions 15a-15c may be illuminated at a first time so as to form a first subset of measurement beams 17a-17c and a second subset of patterned regions 15a-15c may be illuminated at a second time so as to form a second subset of measurement beams 17a-17c.

In other embodiments the mode of the illumination system IL may be unchanged in order to perform a determination of aberrations caused by the projection system PL. For example, the illumination system IL may be configured to illuminate the measurement patterning device MA' with a slit of radiation (e.g. which substantially corresponds with an illumination area used during exposure of substrates). Separate measurement beams 17a-17c may then be formed by the measurement patterning device MA' since only the patterned regions 15a-15c reflect or scatter radiation towards the projection system PS.

In the Figures the Cartesian co-ordinate system is shown as being conserved through the projection system PS. However, in some embodiments the properties of the projection system PS may lead to a transformation of the co-ordinate system. For example, the projection system PS may form an image of the measurement patterning device MA' which is magnified, rotated and/or mirrored relative to the measurement patterning device MA'. In some embodiments the projection system PS may rotate an image of the measurement patterning device MA' by approximately 180° around the z-axis. In such an embodiment the relative positions of a first measurement beam 17a and a third measurement beam 17c which are shown in Figure 2, may be swapped. In other embodiments the image may be mirrored about an axis which may lie in an x-y plane. For example, the image may be mirrored about the x-axis or about the y-axis.

In embodiments in which the projection system PS rotates an image of the measurement patterning device MA' and/or the image is mirrored by the projection system PS, the projection system is considered to transform the co-ordinate system. That is, the co-ordinate system which is referred to herein is defined relative to an image which is projected by the projection system PS and any rotation and/or mirroring of the image causes a corresponding rotation and/or mirroring of the co-ordinate system. For ease of illustration, the co-ordinate system is shown in the Figures as being conserved by the projection system PS. However, in some embodiments the co-ordinate system may be transformed by the projection system PS.

The patterned regions 15a-15c modify the measurement beams 17a-17c. In particular, the patterned regions 15a-15c cause a spatial modulation of the measurement beams 17a-17c and cause diffraction in the measurement beams 17a-17c. In the embodiment which is shown in Figure 3B the patterned regions 15a-15c each comprise two distinct portions. For example, a first patterned region 15a comprises a first portion 15a' and a second portion 15a". The first portion 15a' comprises a diffraction grating which is aligned parallel to a u-direction and the second portion 15a" comprises a diffraction grating which is aligned parallel to a v-direction. The u and v-directions are depicted in Figure 3A. The u and v-directions are both aligned at approximately 45° relative to both the x and y-directions and are aligned perpendicular to each other. Second 15b and third 15c patterned regions which are shown in Figure 3A are identical to the first patterned region 15a and each comprise first and second portions whose diffraction gratings are aligned perpendicular to each other.

The first and second portions of the patterned regions 15a-15c may be illuminated with the measurement beams 17a-17c at different times. For example, the first portions of each of the patterned regions 15a-15c may be illuminated by the measurement beams 17a-17c at a first time. At a second time the second portions of each of the patterned regions 15a-15c may be illuminated by the measurement beams 17a-17c. As was mentioned above in some embodiments different patterned regions 15a-15c may be illuminated at different times. For example, the first portions of a first subset of patterned regions 15a-15c may be illuminated at a first time and the first portions of a second subset of patterned regions 15a-15c may be illuminated at a second time. Second portions of the first and second subsets of patterned regions may be illuminated at the same or different times. In general any schedule of illuminating different portions of patterned regions 15a-15c may be used.

The modified measurement beams 17a-17c are received by the projection system PS. The projection system PS forms an image of the patterned regions 15a-15c on the sensor apparatus 21. The sensor apparatus 21 comprises a plurality of diffraction gratings 19a-19c and a radiation detector 23. The diffraction gratings 19a-19c are arranged such that each diffraction grating 19a-19c receives a respective modified measurement beam 17a-17c which is output from the projection system PL. The modified measurement beams 17a-17c which are incident on the diffraction gratings 19a-19c are further modified by the diffraction gratings 19a-19c. The modified measurement beams which are transmitted at the diffraction gratings 19a-19c are incident on the radiation detector 23.

The radiation detector 23 is configured to detect the spatial intensity profile of radiation which is incident on the radiation detector 23. The radiation detector 23 may, for example, comprise an array of individual detector elements or sensing elements. For example, the radiation detector 23 may comprise an active pixel sensor such as, for example, a CMOS (complementary metal-oxide-semiconductor) sensor array. Alternatively, the radiation detector 23 may comprise a CCD (charge-coupled device) sensor array. The diffraction gratings 19a-19c and portions of the radiation sensor 23 at which the modified measurement beams 17a-17c are received form detector regions 25a-25c. For example, a first diffraction grating 19a and a first portion of the radiation sensor 23 at which a first measurement beam 17a is received together form a first detector region 25a. A measurement of a given measurement beam 17a-17c may be made at a respective detector region 25a-25c (as depicted). As was described above, in some embodiments the relative positioning of the modified measurement beams 17a-17c and the co-ordinate system may be transformed by the projection system PS.

The modification of the measurement beams 17a-17c which occurs at the patterned regions 15a-15c and the diffraction gratings 19a-19c of the detector regions 25a-25c results in interference patterns being formed on the radiation detector 23. The interference patterns are related to the derivative of the phase of the measurement beams and depend on aberrations caused by the projection system PS. The interference patterns may therefore be used to determine aberrations which are caused by the projection system PS.

In general, the diffraction gratings 19a-19c of each of the detector regions 25a-25c comprises a two-dimensional transmissive diffraction grating. In the embodiment which is shown in Figure 3B the detector regions 25a-25c each comprise a diffraction grating 19a-19c which is configured in the form of a checkerboard. As described further below, embodiments of the present invention have particular application to arrangements where the detector regions 25a-25c each comprises a two-dimensional transmissive diffraction grating 19a-19c that is not configured in the form of a checkerboard.

Illumination of the first portions of the patterned regions 15a-15c may provide information related to aberrations in a first direction and illumination of the second portions of the patterned regions 15a-15c may provide information related to aberrations in a second direction.

In some embodiments, the measurement patterning device MA' and/or the sensor apparatus 21 is sequentially scanned and/or stepped in two perpendicular directions. For example, the measurement patterning device MA' and/or the sensor apparatus 21 may be stepped relative to each other in the u and v-directions. The measurement patterning device MA' and/or the sensor apparatus 21 may be stepped in the u-direction whilst the second portions 15a"- 15c" of the patterned regions 15a-15c are illuminated and the measurement patterning device MA' and/or the sensor apparatus 21 may be stepped in the v-direction whilst the first portions 15a'-15c' of the patterned regions 15a-15c are illuminated. That is, the measurement patterning device MA' and/or the sensor apparatus 21 may be stepped in a direction which is perpendicular to the alignment of a diffraction grating which is being illuminated.

The measurement patterning device MA' and/or the sensor apparatus 21 may be stepped by distances which correspond with a fraction of the grating period of the diffraction gratings. Measurements which are made at different stepping positions may be analysed in order to derive information about a wavefront in the stepping direction. For example, the phase of the first harmonic of the measured signal (which may be referred to as a phase stepping signal) may contain information about the derivative of a wavefront in the stepping direction. Stepping the measurement patterning device MA' and/or the sensor apparatus 21 in both the u and v-directions (which are perpendicular to each other) therefore allows information about a wavefront to be derived in two perpendicular directions (in particular, it provides information about a derivative of the wavefront in each of the two perpendicular directions), thereby allowing the full wavefront to be reconstructed.

In addition to stepping of the measurement patterning device MA' and/or the sensor apparatus 21 in a direction which is perpendicular to the alignment of a diffraction grating which is being illuminated (as was described above), the measurement patterning device MA' and/or the sensor apparatus 21 may also be scanned relative to each other. Scanning of the measurement patterning device MA' and/or the sensor apparatus 21 may be performed in a direction which is parallel to the alignment of a diffraction grating which is being illuminated. For example, the measurement patterning device MA' and/or the sensor apparatus 21 may be scanned in the u-direction whilst the first portions 15a'-15c' of the patterned regions 15a-15c are illuminated and the measurement patterning device MA' and/or the sensor apparatus 21 may be scanned in the v-direction whilst the second portions 15a"-15c" of the patterned regions 15a-15c are illuminated. Scanning of the measurement patterning device MA' and/or the sensor apparatus 21 in a direction which is parallel to the alignment of a diffraction grating which is being illuminated allows measurements to be averaged out across the diffraction grating, thereby accounting for any variations in the diffraction grating in the scanning direction. Scanning of the measurement patterning device MA' and/or the sensor apparatus 21 may be performed at a different time to the stepping of the measurement patterning device MA' and/or the sensor apparatus 21 which was described above.

It will be appreciated that a variety of different arrangements of the patterned regions 15a-15c and the detector regions 25a-25c may be used in order to determine aberrations caused by the projection system PS. The patterned regions 15a-15c and/or the detector regions 25a-25c may comprise diffraction gratings. In some embodiments the patterned regions 15a-15c and/or the detector regions 25a-25c may comprise components other than a diffraction grating. For example, in some embodiments the patterned regions 15a-15c and/or the detector regions may comprise a single slit or a pin-hole opening through which at least a portion of a measurement beam 17a-17c may propagate. In general the patterned regions and/or the detector regions may comprise any arrangement which serves to modify the measurement beams.

The controller CN receives measurements made at the sensor apparatus 21 and determines, from the measurements, aberrations which are caused by the projection system PS. The controller may be configured to control one or more components of the measurement system 10. For example, the controller CN may control a positioning apparatus PW which is operable to move the sensor apparatus 21 and/or the measurement patterning device MA' relative to each other. The controller may control an adjusting means PA for adjusting components of the projection system PS. For example, the adjusting means PA may adjust optical elements of the projection system PS so as to correct for aberrations which are caused by the projection system PS and which are determined by the controller CN.

In some embodiments, the controller CN may be operable to control the adjusting means PA for adjusting the support structure MT and/or the substrate table WT. For example, the adjusting means PA may adjust support structure MT and/or substrate table WT so as to correct for aberrations which are caused by placement errors of patterning device MA and/or substrate W (and which are determined by the controller CN).

Determining aberrations (which may be caused by the projection system PS or by placement errors of the patterning device MA or the substrate W) may comprise fitting the measurements which are made by the sensor apparatus 21 to Zernike polynomials in order to obtain Zernike coefficients. Different Zernike coefficients may provide information about different forms of aberration which are caused by the projection system PS. Zernike coefficients may be determined independently at different positions in the x and/or the y-directions. For example, in the embodiment which is shown in Figure 2, 3A and 3B, Zernike coefficients may be determined for each measurement beam 17a-17c.

In some embodiments the measurement patterning device MA' may comprise more than three patterned regions, the sensor apparatus 21 may comprise more than three detector regions and more than three measurement beams may be formed. This may allow the Zernike coefficients to be determined at more positions. In some embodiments the patterned regions and the detector regions may be distributed at different positions in both the x and y-directions. This may allow the Zernike coefficients to be determined at positions which are separated in both the x and the y-directions.

Whilst, in the embodiment which is shown in Figures 2, 3A and 3B the measurement patterning device MA' comprises three patterned regions 15a-15c and the sensor apparatus 21 comprises three detector regions 25a-25c, in other embodiments the measurement patterning device MA' may comprise more or less than three patterned regions 15a-15c and/or the sensor apparatus 21 may comprise more or less than three detector regions 25a-25c.

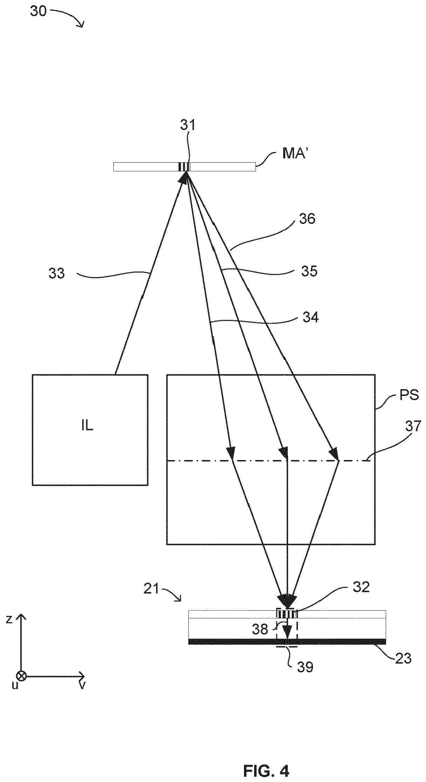

Methods for determining aberrations caused by a projection system PS are now described with reference to Figure 4.

In general, measurement patterning device MA' comprises at least one first patterned region 15a-15c and the sensor apparatus 21 comprises at least one second patterned region 19a-19c.

Figure 4 is a schematic illustration of a measurement system 30 which may be used to determine aberrations which are caused by a projection system PS. Measurement system 30 may be the same as the measurement system 10 shown in Figure 2, however, it may have a different number of first patterned regions (on measurement patterning device MA') and second patterned regions (in the sensor apparatus 21). Therefore, the measurement system 30 shown in Figure 4 may include any features of the measurement system 10 shown in Figure 2 described above and these features will not be further described below.

In Figure 4, only a single first patterned region 31 is provided on the measurement patterning device MA' and a single second patterned region 32 is provided in the sensor apparatus 21.

The measurement patterning device MA' is irradiated with radiation 33 from the illumination system IL. For ease of understanding only a single line (which may, for example, represent a single ray, for example the chief ray, of an incident radiation beam) is shown in Figure 4. However, it will be appreciated that the radiation 33 will comprise a range of angles incident on the first patterned region 31 of the measurement patterning device MA'. That is, each point on the first patterned region 31 of the measurement patterning device MA' may be illuminated by a cone of light. In general, each point is illuminated by substantially the same range of angles, this being characterized by the intensity of radiation in a pupil plane of the illumination system IL (not shown).

The first patterned region 31 is arranged to receive the radiation 33 and to form a plurality of first diffraction beams 34, 35, 36. A central first diffraction beam 35 corresponds to a $0^{th}$ order diffraction beam of first patterned region 31 and the other two first diffraction beams 34, 36 correspond to the $\pm 1^{st}$ order diffraction beams of first patterned region 31. It will be appreciated that more, higher order diffraction beams will, in general, also be present. Again for ease of understanding, only three first diffraction beams 34, 35, 36 are shown in Figure 4.

It will also be appreciated that, as the incoming radiation 33 comprises a cone of radiation converging on a point on the first patterned region 31, each of the first diffraction beams 34, 35, 36 also comprises a cone of radiation diverging from that point on the first patterned region 31.

To achieve the generation of the first diffraction beams 34, 35, 36, the first patterned region 31 may be of the form of a diffraction grating. For example, the first patterned region 31 may be generally of the form of the patterned region 15a shown in Figure 3A. In particular, at least a portion of the first patterned region 31 may be of the form of the first portion 15a' of the patterned region 15a shown in Figure 3A, i.e. a diffraction grating which is aligned parallel to a u-direction (note that Figure 4 is shown in the z-v plane). Therefore, the first diffraction beams 34-36 are separated in a shearing direction, which is the v-direction.

The first diffraction beams 34-36 are at least partially captured by the projection system PS, as now described. How much of the first diffraction beams 34-36 is captured by the projection system PS will be dependent on: the pupil fill of the incident radiation 33 from the illumination system IL; the angular separation of the first diffraction beams 34-36 (which in turn is dependent on the pitch of the first patterned region 31 and the wavelength of the radiation 33); and the numerical aperture of the projection system PS.

The measurement system 30 may be arranged such that first diffraction beam 35 that corresponds to the $0^{th}$ order diffraction beam substantially fills the numerical aperture of the projection system PS, which may be represented by a circular region of a pupil plane 37 of the projection system PS, and the first diffraction beams 34, 36 that correspond to the $\pm 1^{st}$ order diffraction beams overlap significantly with the first diffraction beam 35 that corresponds to the $0^{th}$ order diffraction beam. With such an arrangement, substantially all of the first diffraction beam 35 that corresponds to the $0^{th}$ order diffraction beam and most of the first diffraction beams 34, 36 that correspond to the $\pm 1^{st}$ order diffraction beams is captured by the projection system PS and projected onto the sensor apparatus 21. (Furthermore, with such an arrangement a large number of diffraction beams generated by the first patterned region 31 are at least partially projected onto the sensor apparatus 21).

The role of the first patterned region 31 is to introduce spatial coherence, as now discussed.

In general, two rays of radiation 33 from the illumination system IL that are incident on the same point of the measurement patterning device MA' at different angles of incidence are not coherent. By receiving the radiation 33 and forming a plurality of first diffraction beams 34, 35, 36, the first patterned region 31 may be considered to form a plurality of copies of the incident radiation cone 33 (the copies having, in general different phases and intensities). Within any one of these copies, or first diffraction beams 34, 35, 36, two rays of radiation which originate from the same point on the measurement patterning device MA' but at different scattering angles, are not coherent (due to the properties of the illumination system IL). However, for a given ray of radiation within any one of the first diffraction beams 34, 35, 36 there is a corresponding ray of radiation in each of the other first diffraction beams 34, 35, 36 that is spatially coherent with that given ray. For example, the chief rays of each of the first diffraction beams 34, 35, 36 (which correspond to the chief ray of the incident radiation 33) are coherent and could, if combined, interfere at the amplitude level.

This coherence is exploited by the measurement system 30 to determine an aberration map of the projection system PS.

The projection system PS projects part of the first diffraction beams 34, 35, 36 (which is captured by the numerical aperture of the projection system) onto the sensor apparatus 21.

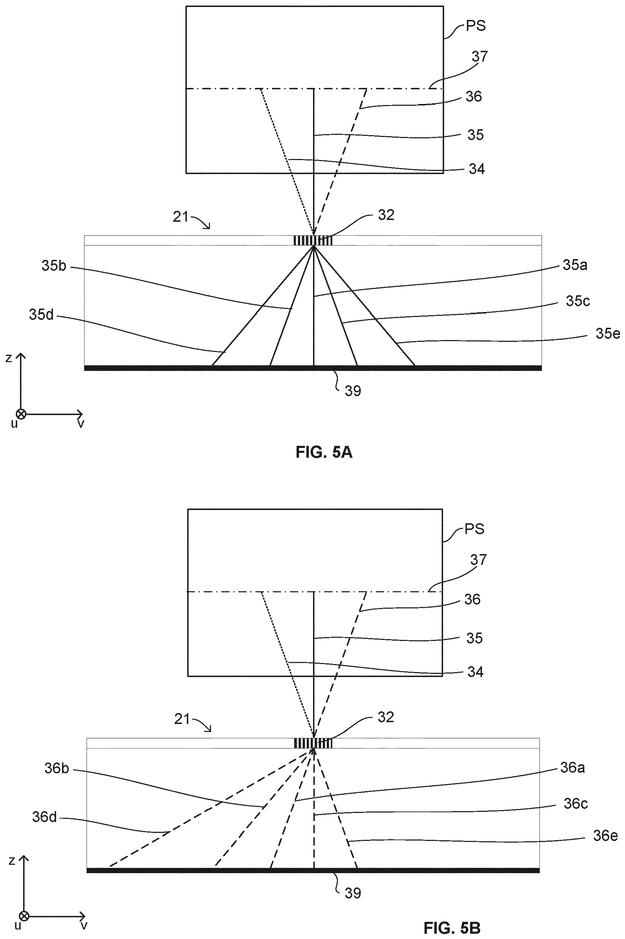

In Figure 4, the sensor apparatus 21 comprises the single second patterning region 32. As described further below (with reference to Figures 5A-5C), second patterned region 32 is arranged to receive these first diffraction beams 34-36 from the projection system PS and to form a plurality of second diffraction beams from each of the first diffraction beams. In order to achieve this, the second patterning region 32 comprises a two-dimensional transmissive diffraction grating. In Figure 4, all radiation that is transmitted by the second patterning region 32 is represented as a single arrow 38. This radiation 38 is received by a detector region 39 of the radiation detector 23 and is used to determine the aberration map.

Each of the first diffraction beams 34-36 that is incident on the patterning region 32 will diffract to from a plurality of second diffraction beams. Since the second patterning region 32 comprises a two-dimensional diffraction grating, from each incident first diffraction beam, a two dimensional array of secondary diffraction beams is produced (the chief rays of these secondary diffraction beams being separated in both the shearing direction (v-direction) and the direction perpendicular thereto (the u-direction). In the following, a diffraction order that is $n^{th}$ order in the shearing direction (the v-direction) and $m^{th}$ order in the non-shearing direction (the u-direction) will be referred to as the $(n, m)^{th}$ diffraction order of the second patterned region 32. In the following, where it is not important what order a second diffraction beam is in the non-shearing direction (the u-direction), the $(n, m)^{th}$ diffraction order of the second patterned region 32 may be referred to simply as the $n^{th}$ order second diffraction beam.

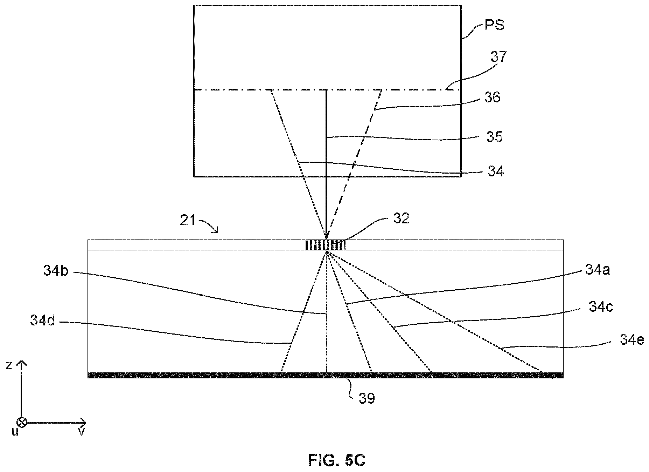

Figures 5A to 5C show a set of second diffraction beams produced by each of the first diffraction beams 34-36. Figure 5A shows a set of second diffraction beams 35a-35e produced by the first diffraction beam 35 that corresponds to the $0^{th}$ order diffraction beam of first patterned region 31. Figure 5B shows a set of second diffraction beams 36a-36e produced by the first diffraction beam 36 that corresponds to the $-1^{st}$ order diffraction beam of first patterned region 31. Figure 5C shows a set of second diffraction beams 34a-34e produced by the first diffraction beam 34 that corresponds to the $+1^{st}$ order diffraction beam of first patterned region 31.

In Figure 5A, second diffraction beam 35a corresponds to the $0^{th}$ order diffraction beam (of second patterned region 32, and in the shearing direction), whereas second diffraction beams 35b, 35c correspond to the $\pm 1^{st}$ order diffraction beams and second diffraction beams 35d, 35e correspond to the $\pm 2^{nd}$ order diffraction beams. It will be appreciated that Figures 5A-5C are shown in the v-z plane and the shown second diffraction beams may, for example, correspond to $0^{th}$ order diffraction beam of second patterned region 32 in the non-shearing direction (i.e. the u-direction). It will be further appreciated that there will be a plurality of copies of these second diffraction beams, representing higher order diffraction beams in the non-shearing direction that are into or out of the page of Figures 5A-5C.

In Figure 5B, second diffraction beam 36a corresponds to the $0^{th}$ order diffraction beam (of second patterned region 32, and in the shearing direction), whereas second diffraction beams 36b, 36c correspond to the $\pm 1^{st}$ order diffraction beams and second diffraction beams 36d, 36e correspond to the $\pm 2^{nd}$ order diffraction beams.

In Figure 5C, second diffraction beam 34a corresponds to the $0^{th}$ order diffraction beam (of second patterned region 32, and in the shearing direction), whereas second diffraction beams 34b, 34c correspond to the $\pm 1^{st}$ order diffraction beams and second diffraction beams 34d, 34e correspond to the $\pm 2^{nd}$ order diffraction beams.

It can be seen from Figures 5A-5C that several of the second diffraction beams spatially overlap with each other. For example, the second diffraction beam 35b that corresponds to the $-1^{st}$ order diffraction beam of second patterned region 32, which originates from the $0^{th}$ order diffraction beam 35 of first patterned region 31 overlaps with the second diffraction beam 36a that corresponds to the $0^{th}$ order diffraction beam of second patterned region 32, which originates from the $-1^{st}$ order diffraction beam 36 of first patterned region 31. All of the lines in Figures 4 and 5A-5C may be considered to represent a single ray of radiation that originates from a single input ray 33 from the illumination system IL. Therefore, as explained above, these lines represent spatially coherent rays that, if spatially overlapping at radiation detector 23 will produce an interference pattern. Furthermore, the interference is between rays which have passed though different parts of the pupil plane 37 of the projection system PS (which are separated in the shearing direction). Therefore, the interference of radiation that originates from a single input ray 33 is dependent on phase differences between two different parts of the pupil plane.

This spatial overlapping and spatial coherence of the second diffraction beams at radiation detector 23 is achieved by matching the first and second patterned regions 31, 32 such that the angular separation (in the shearing direction) between different second diffraction beams that originate from a given first diffraction beam is the same as the angular separation (in the shearing direction) between different first diffraction beams as they converge on the second patterned region 32. This spatial overlapping and spatial coherence of the second diffraction beams at radiation detector 23 is achieved by matching the pitches of the first and second patterned regions 31, 32 in the shearing direction. It will be appreciated that this matching of the pitches of the first and second patterned regions 31, 32 in the shearing direction takes into account any reduction factor applied by the projection system PS. As used herein, the pitch of a two dimensional diffraction grating in a particular direction is defined as follows.

It will be appreciated that a one-dimensional diffraction grating comprises a series of lines that are formed from a repeating pattern (of reflectivity or transmissivity) in a direction perpendicular to these lines. In the direction perpendicular to the lines, the smallest non-repeating section from which the repeating pattern is formed is referred to as the unit cell and the length of this unit cell is referred to as the pitch of the one-dimensional diffraction grating. In general, such a one-dimensional diffraction grating will have a diffraction pattern such that an incident radiation beam will be diffracted so as to form a one-dimensional array of angularly spaced (but potentially spatially overlapping) diffraction beams. The first patterned region 31 forms such a one-dimensional array of angularly spaced first diffraction beams 34-36, which are offset (angularly spaced) in the shearing direction.

It will be appreciated that a two-dimensional diffraction grating comprises a two-dimensional repeating pattern of reflectivity or transmissivity. The smallest non-repeating section from which this repeating pattern is formed may be referred to as the unit cell. The unit cell may be square and a fundamental pitch of such a two-dimensional diffraction grating may be defined as a length of the square unit cell. In general, such a two dimensional diffraction grating will have a diffraction pattern such that an incident radiation beam will be diffracted so as to form a two dimensional array of, angularly spaced (but potentially spatially overlapping) diffraction beams. The axes of this two-dimensional (square) array of diffraction beams are parallel to the sides of the unit cell. The angular separation between adjacent diffraction beams in these two directions may be given by the ratio of the wavelength of the radiation to the pitch of the grating. Therefore, the smaller the pitch, the larger the angular separation between the adjacent diffraction beams.

In some embodiments, the axes of the unit cell of the two-dimensional second patterned region 32 may be arranged at a non-zero angle to the shearing and non-shearing directions as defined by the first patterned region 31. For example, the axes of the unit cell of the two-dimensional second patterned region 32 may be arranged at 45° to the shearing and non-shearing directions as defined by the first patterned region 31. As previously explained, spatial overlapping and spatial coherence of the second diffraction beams at radiation detector 23 which allows the wavefront to be measured is achieved by ensuring that that the angular separation (in the shearing direction) between different second diffraction beams that originate from a given first diffraction beam is the same as the angular separation (in the shearing direction) between different first diffraction beams as they converge on the second patterned region 32. For an arrangement wherein the axes of the unit cell of the two-dimensional second patterned region 32 are arranged at a non-zero angle (for example 45°) to the shearing and non-shearing directions, it can be useful to define a pseudo-unit cell and a pseudo-pitch as follows. The pseudo-unit cell is defined as the smallest non-repeating square from which the repeating pattern of the diffraction grating is formed, which is orientated such that its sides are parallel to the shearing and non-shearing directions (as defined by the first patterned region 31. The pseudo-pitch may be defined as a length of the square pseudo-unit cell. This may be referred to as the pitch of a two dimensional diffraction grating in the shearing direction. It is this pseudo-pitch which should be matched to (an integer multiple or fraction of) the pitch of the first patterned region 31.

The diffraction pattern of the diffraction grating may be considered to form a two dimensional array of angularly spaced (but potentially spatially overlapping) pseudo-diffraction beams, the axes of this two-dimensional (square) array of pseudo-diffraction beams being parallel to the sides of the pseudo-unit cell. Since this square is not the unit cell (defined as to the smallest square of any orientation from which the repeating pattern of the diffraction grating is formed), the pseudo-pitch will be larger than the pitch (or fundamental pitch). Therefore, there will a smaller separation between adjacent pseudo-diffraction beams in the diffraction pattern (in a direction parallel to the sides of the pseudo-unit cell) than there is between adjacent diffraction beams in the diffraction pattern (in a direction parallel to the sides of the unit cell). This can understood as follows. Some of the pseudo-diffraction beams correspond to diffraction beams in the diffraction pattern and the other pseudo-diffraction beams are unphysical and do not represent a diffraction beam generated by the diffraction grating (and only arise due to the use of a pseudo-unit cell that is larger than the true unit cell).

Taking any reduction (or enlargement) factor applied by the projection system PS into account, either the pitch of the second patterned region 32 in the shearing direction should be an integer multiple of the pitch of the first patterned region 31 in the shearing direction or the pitch of the first patterned region 31 in the shearing direction should be an integer multiple of the pitch of the second patterned region 32 in the shearing direction. In the example shown in Figures 5A-5C, the pitches of the first and second patterned regions 31, 32 in the shearing direction are substantially equal (taking into account any reduction factor).

As can be seen from Figures 5A-5C, each point on the detector region 39 of the radiation detector 23 will, in general, receive several contributions that are summed coherently. For example, the point on the detector region 39 which receives the second diffraction beam 35b that corresponds to the $-1^{st}$ order diffraction beam of second patterned region 32, which originates from the $0^{th}$ order diffraction beam 35 of first patterned region 31 overlaps with both: (a) the second diffraction beam 36a that corresponds to the $0^{th}$ order diffraction beam of second patterned region 32, which originates from the $-1^{st}$ order diffraction beam 36 of first patterned region 31; and (b) the second diffraction beam 34d that corresponds to the $-2^{nd}$ order diffraction beam of second patterned region 32, which originates from the $+1^{st}$ order diffraction beam 34 of first patterned region 31. It will be appreciated that when higher order diffraction beams of the first patterned region 31 are taken into account there will be more beams that should be summed coherently at each point on the detector region 39 in order to determine the intensity of radiation as measured by that part of the detector region 39 (for example a corresponding pixel in a two dimensional array of sensing elements).

In general, a plurality of different second diffraction beams contributes to the radiation received by each part of the detector region 39. The intensity of radiation from such a coherent sum is given by:

$$(2)$$

$$I = DC + \sum_{\text{pairs } \{i\}} \gamma_i \cos(\Delta\phi_i),$$

where $DC$ is a constant term (which is equivalent to the incoherent sum of the different diffraction beams), the sum is over all pairs of different second diffraction beams, $\gamma_i$ is an interference strength for that pair of second diffraction beams and $\Delta\phi_i$ is a phase difference between that pair of second diffraction beams.

The phase difference $\Delta\phi_i$ between a pair of second diffraction beams is dependent on two contributions: (a) a first contribution relates to the different part of the pupil plane 37 of the projection system PS from which they originate; and (b) a second contribution relates to the position within the unit cells of each of the first and second patterned regions 31, 32 from which they originate.

The first of these contributions can be understood to arise from the fact that the different coherent radiation beams have passed through different parts of the projection system PS and are therefore related to the aberrations that it is desired to determine (in fact they are related to a difference between two points in the aberration map that are separated in the shearing direction).

The second of these contributions can be understood to arise from the fact that the relative phases of multiple rays of radiation that arise from a single ray incident on a diffraction grating will depend on which part of the unit cell of that grating the ray was incident. This therefore does not contain information relating to the aberrations. As explained above, in some embodiments, the measurement patterning device MA' and/or the sensor apparatus 21 are sequentially scanned and/or stepped in the shearing direction. This causes the phase differences between all of pairs of interfering radiation beams received by the radiation detector 23 to change. As the measurement patterning device MA' and/or the sensor apparatus 21 are sequentially stepped in the shearing direction by an amount that is equivalent to a fraction of the pitches (in the shearing direction) of the first and second patterned regions 31, 32, in general, the phase differences between pairs of second diffraction beams will all change. If the measurement patterning device MA' and/or the sensor apparatus 21 are stepped in the shearing direction by an amount that is equivalent to an integer multiple of the pitches (in the shearing direction) of the first and second patterned regions 31, 32 the phase differences between pairs of second diffraction beams will remain the same. Therefore, as the measurement patterning device MA' and/or the sensor apparatus 21 are by sequentially scanned and/or stepped in the shearing direction, the intensity received by each part of the radiation detector 23 will oscillate. The first harmonic of this oscillating signal (which may be referred to as a phase-stepping signal), as measured by the radiation detector 23, is dependent on the contributions to equation (1) that arise from adjacent first diffraction beams 34-36, i.e. first diffraction beams that differ in order by $\pm 1$. Contributions that arise from first diffraction beams that differ in order by a different amount will contribute to higher order harmonics of the signal determined by the radiation detector 23 due to such phase stepping techniques.

For example, of the three overlapping second diffraction beams discussed above (35b, 36a and 34d) only two of the three possible pairs of these diffraction beams will contribute to the first harmonic of the phase stepping signal: (a) second diffraction beams 35b and 36a (which originate from the $0^{th}$ order diffraction beam 35 and the $-1^{st}$ order diffraction beam 36 of first patterned region 31 respectively); and (b) second diffraction beams 35a and 34d (which originate from the $0^{th}$ order diffraction beam 35 and the $+1^{st}$ order diffraction beam 34 of first patterned region 31 respectively).

Each pair of second diffraction beams will result in an interference term of the form shown in equation (2), which contributes to the first harmonic of the phase stepping signal, i.e. an interference term of the form:

$$(3)$$

$$\gamma \cos(\frac{2\pi}{p} \cdot v + \Delta W)$$

where y is an amplitude of the interference term, $p$ is the pitch of the first and second patterned regions 31, 32 (in the shearing direction), v parameterizes the relative positions of the first and second patterned regions 31, 32 in the shearing direction and $\Delta W$ is a difference between the value of the aberration map at two positions in the pupil plane of the projection system PS, the two positions corresponding to the positions from which the two second diffraction beams originate. The amplitude y of the interference term is proportional to the product of the compound scattering efficiencies of the two second diffraction beams, as discussed further below. The frequency of the first harmonic of the phase stepping signal is given by the inverse of the pitch $p$ of the first and second patterned regions 31, 32 in the shearing direction. The phase of the phase stepping signal is given by $\Delta W$ (the difference between the values of the aberration map at two positions in the pupil plane of the projection system PS, the two positions corresponding to the positions from which the two second diffraction beams originate).

The interference strength $\gamma_i$ for a pair of second diffraction beams is proportional to the product of the compound scattering efficiencies of the two second diffraction beams, as now discussed.

In general, the scattering efficiency of the diffraction beams produced by a diffraction grating will depend on the geometry of the grating. These diffraction efficiencies, which may be normalised to the efficiency of a $0^{th}$ order diffraction beam, describe the relative intensities of the diffraction beams. As used herein, the compound scattering efficiency of a second diffraction beam is given by the product of the scattering efficiency of the first diffraction beam from which it originates and the scattering efficiency for the diffraction order of the second patterned region 32 to which it corresponds.

In the above description of the embodiments shown in Figures 3A to 5C, where the first portion 15a' of the patterned region 15a shown in Figure 3A is illuminated, the shearing direction corresponds to the v-direction and the non-shearing direction corresponds to the u-direction. It will be appreciated that when the second portion 15a" of the patterned region 15a shown in Figure 3A is illuminated, the shearing direction corresponds to the u-direction and the non-shearing direction corresponds to the v-direction. Although in these above-described embodiments, the u and v-directions (which define the two shearing directions) are both aligned at approximately 45° relative to both the x and y-directions of the lithographic apparatus LA, it will be appreciated that in alternative embodiments the two shearing directions may be arranged at any angle to the x and y-directions of the lithographic apparatus LA (which may correspond to non-scanning and scanning directions of the lithographic apparatus LA). In general, the two shearing directions will be perpendicular to each other. In the following, the two shearing directions will be referred to as the x-direction and the y-direction. However, it will be appreciated that these shearing directions may be arranged at any angle relative to both the x and y-directions of the lithographic apparatus LA.

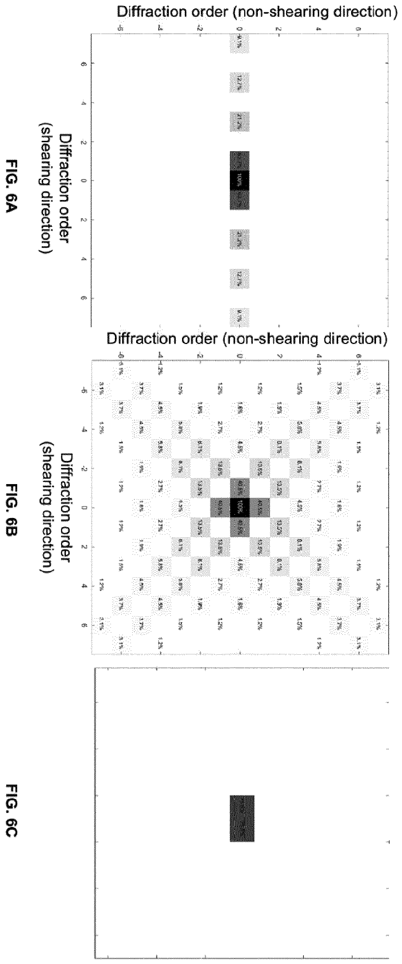

Figure 6A shows the scattering efficiency for a first patterned region 31 that is of the form of the first portion 15a' of the patterned region 15a shown in Figure 3A, having a 50% duty cycle. The horizontal axis represents the diffraction order in the shearing direction. The diffraction efficiencies shown in Figure 6A are normalised to the efficiency of a $0^{th}$ order diffraction beam, such that the efficiency of the $0^{th}$ order diffraction beam is 100%. With this geometry (a 50% duty cycle), the efficiencies of the even diffraction orders (except the $0^{th}$ diffraction order) are zero. The efficiencies of the $\pm 1^{st}$ order diffraction beams are 63.7%.

Figure 6B shows the scattering efficiency for a second patterned region 32 that is of the form of the diffraction grating 19a shown in Figure 3B, i.e. in the form of a checkerboard with a 50% duty cycle. The horizontal axis represents the diffraction order in the shearing direction. The vertical axis represents the diffraction order in the non-shearing direction. The diffraction efficiencies shown in Figure 6B are normalised to the efficiency of the $(0, 0)^{th}$ order diffraction beam, such that the efficiency of the $(0, 0)^{th}$ order diffraction beam is 100%.

As explained above, the first harmonic of the oscillating phase-stepping signal only depends on the contributions to equation (1) from first diffraction beams that differ in order by $\pm 1$. As can be seen from Figure 6A, with a 50% duty cycle grating on the measurement patterning device MA', the only two pairs of first diffraction beams that differ in order by $\pm 1$ are the $0^{th}$ order beam with either the $\pm 1^{st}$ order beams. Furthermore, with this geometry for the first patterned region 31, the scattering efficiencies are symmetric such that the efficiencies of the $\pm 1^{st}$ order diffraction beams are both the same (63.7%). Therefore, the interference strengths $\gamma_i$ for all pairs of second diffraction beams that contribute to the first harmonic of the oscillating phase-stepping signal can be determined as follows. A second copy of the scattering efficiency plot for the second patterned region 32 shown in Figure 6B is weighted by the scattering efficiency for the $\pm 1^{st}$ order diffraction beams of the first patterned region 31 and then overlaid with the scattering efficiency plot for the second patterned region 32 shown in Figure 6B but shifted in the shearing direction by the separation of 1 pair of diffraction orders (of the first patterned region 31). Here, the pitches of the first and second patterned regions 31, 32 in the shearing direction are equal (taking into account any reduction factor applied by the projection system PS) and therefore, in this example, the second copy of the scattering efficiency plot for the second patterned region 32 is a shifted in the shearing direction by 1 diffraction order of the second patterned region 31. The product of the scattering efficiencies of these two overlaid scattering efficiencies plots is then determined. Such a plot of the interference strengths $\gamma_i$ for all pairs of second diffraction beams that contribute to the first harmonic of the oscillating phase-stepping signal is shown in Figure 6C.

Note that each of the interference strengths $\gamma_i$ shown in Figure 6C actually represents two different pairs of second diffraction beams. For example, the left hand pixel shown in Figure 6C represents both: (a) interference between second diffraction beams 35a and 34b and (b) second diffraction beam 35b and 36a. Similarly, the right hand pixel shown in Figure 6C represents both: (a) interference between second diffraction beam 35a and 36c and (b) second diffraction beam 35c and 34a. In general, each pixel of such a map represents two pairs of second diffraction beams: (a) a first pair of second diffraction beams that include one second diffraction beam that originated from the first diffraction beam 35 corresponding to the $0^{th}$ diffraction order of first patterning device 31 and another second diffraction beam that originated from the first diffraction beam 34 corresponding to the $+1^{st}$ diffraction order of first patterned region 31; and (b) a second pair of second diffraction beams that include one second diffraction beam that originated from the first diffraction beam 35 corresponding to the $0^{th}$ diffraction order of first patterning device 31 and another second diffraction beam that originated from the first diffraction beam 36 corresponding to the $-1^{st}$ diffraction order of first patterned region 31.

In general, each of the interference strengths $\gamma_i$ shown in Figure 6C represents two different pairs of second diffraction beams: (a) one pair comprising an $n^{th}$ order second diffraction beam produced by the first diffraction beam 35 (that corresponds to the $0^{th}$ order diffraction beam of first patterned region 31); and (b) another pair comprising an $(n+1)^{th}$ order second diffraction beam produced by the first diffraction beam 35. Therefore, each interference strength $\gamma_i$ may be characterized by the two diffraction orders of the first diffraction beam 35 $((n, m)^{th}$ and $(n+1, m)^{th})$ that contribute, and may be denoted as $\gamma_{n,n+1;m}$. In the following, where it is clear that m=0, or the value of m is unimportant, this interference strength may be denoted as $\gamma_{n,n+1}$.

Although each of the interference strengths $\gamma_i$ (or $\gamma_{n,n+1;m}$) shown in Figure 6C represents two different pairs of second diffraction beams, each of the interference strengths $\gamma_i$ shown in Figure 6C represents the second diffraction beams which contribute to the first harmonic of the oscillating phase-stepping signal and which have a different overlap, at the radiation detector 23, with a circle that represents the numerical aperture of the projection system PS, as now described.

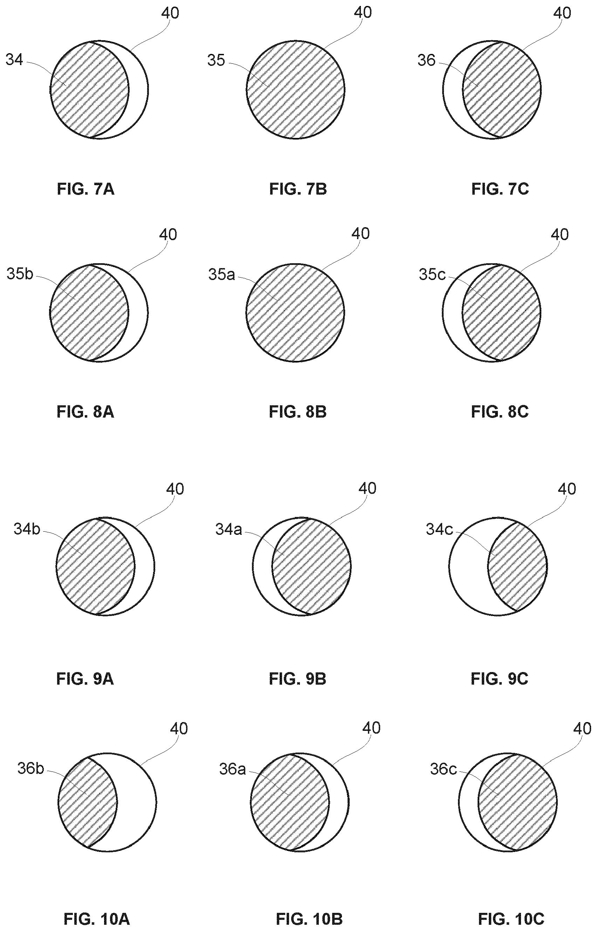

Figures 7A, 7B and 7C show the portion of the pupil plane 37 of the projection system PS which corresponds to the numerical aperture of the projection system PS that is filled by first diffraction beams 34, 35, 36 respectively. In each of Figures 7A, 7B and 7C the numerical aperture of the projection system PS is represented by a circle 40 and the portion of the pupil plane 37 of the projection system PS that is filled by first diffraction beams 34, 35, 36 is shown by a shaded region of this circle 40 in Figures 7A, 7B and 7C respectively. As can be seen from Figure 7B, in the example shown, the central first diffraction beam 35 which corresponds to a $0^{th}$ order diffraction beam substantially fills the numerical aperture of the projection system PS. As can be seen from Figure 7A and 7C, each of the two first diffraction beams 34, 36 which correspond to the $\pm 1^{st}$ order diffraction beams of first patterned region 31 have been shifted such that they only partially fill the numerical aperture. It will be appreciated that this shift of the first order first diffraction beams 34, 36 relative to the numerical aperture is in practice very small and has been exaggerated here for ease of understanding.

Figures 8A-10C show the portion of the radiation detector 23 that is filled by various second diffraction beams. In each of Figures 8A-10C the numerical aperture of the projection system PS is represented by a circle 40 and the portion of this circle that is filled by the second diffraction beams is shown by a shaded region of this circle 40. Figures 8A-8C show the portion of the circle 40 that is filled by $(-1, 0)$th, $(0, 0)$th and $(1, 0)$th order diffraction beams 35b, 35a, 35c which originate from the first diffraction beam 35 which corresponds to a $0$th order diffraction beam of the first patterned region 31. Figures 9A-9C show the portion of the circle 40 that is filled by $(-1, 0)$th, $(0, 0)$th and $(1, 0)$th order diffraction beams 34b, 34a, 34c which originate from the first diffraction beam 34 which corresponds to the $1$st order diffraction beam of the first patterned region 31. Figures 10A-10C show the portion of the circle 40 that is filled by $(-1, 0)$th, $(0, 0)$th and $(1, 0)$th order diffraction beams 36b, 36a, 36c which originate from the first diffraction beam 36 which corresponds to the $-1$st order diffraction beam of the first patterned region 31.

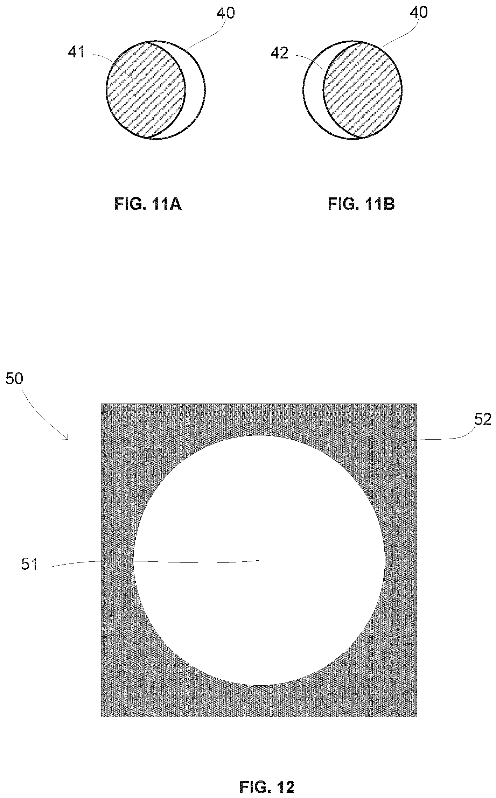

It can be seen from Figures 8B, 9A, 8A and 10B that the region of the radiation detector which receives a contribution from both: (a) interference between second diffraction beams 35a and 34b and (b) second diffraction beam 35b and 36a is the region 41 shown in Figure 11A. Similarly, It can be seen from Figures 8B, 10C, 8C and 9B that the region of the radiation detector which receives a contribution from both: (a) interference between second diffraction beam 35a and 36c and (b) second diffraction beam 35c and 34a is the region 42 shown in Figure 11B.

In general, each of the interference strengths $\gamma_i$ shown in Figure 6C may be considered to represent a beam of radiation formed by a plurality of interfering second interference beams, each such beam of radiation formed by a plurality of interfering second interference beams propagating in a different direction, such that the overlap of each such beam of radiation at the radiation detector 23, with a circle that represents the numerical aperture of the projection system PS is different.

In general, the second diffraction beams can be considered to form a plurality of beams of radiation, each such beam of radiation being formed by a set of interfering second diffraction beams. Each such beam of radiation may be referred to herein as an interference beam. Each such interference beam formed by a plurality of interfering second interference beams may be considered to propagate in a different direction, such that the overlap of each interference beam at the radiation detector 23 with a circle that represents the numerical aperture of the projection system PS is different. Although they may be considered to propagate in different directions and have a different overlap with a circle that represents the numerical aperture of the projection system PS, there is significant overlap between the different interference beams at the radiation detector 23. Each of the interference strengths $\gamma_i$ shown in Figure 6C may be considered to represent a different interference beam (formed by a plurality of interfering second interference beams).

As previously described, each of the interference strengths $\gamma_i$ (or $\gamma_{n,n+1;m}$) shown in Figure 6C represents two different pairs of second diffraction beams. However, for a given position on the radiation detector, both of these pairs of contributing second diffraction beams comprise two interfering rays that originate from the same two points in the pupil plane 37 of the projection system PS. In particular, for a position $(x, y)$ on the radiation detector (these co-ordinates corresponding to co-ordinates of the pupil plane 37 of the projection system PS and the x direction corresponding to the shearing direction), the two pairs of interfering second diffraction beams that contribute and have an interference strengths $\gamma_{n,n+1;m}$ each comprise a ray of a second diffraction beam that originated from a position $(x-ns, y-ms)$ in the pupil plane 37 and a ray of a second diffraction beam that originated from a position $(x-(n+1)s, y-ms)$ in the pupil plane 37, where s is a shearing distance. The shearing distance s corresponds to the distance in the pupil plane 37 between two coherent rays of adjacent first diffraction beams 34-36. Therefore, both pairs of contributing second diffraction beams give rise to an interference term of the form of expression (3), where $\Delta W$ is a difference between the value of the aberration map at these two positions in the pupil plane 37.

It can be seen from Figure 6C that with a second patterned region 32 which is of the form of a 50% duty cycle checkerboard there are only two sets of second diffraction beams that contribute to the first harmonic of the phase stepping signal, both with an interference strength ($\gamma_{-1,0}$, $\gamma_{0,+1}$) of 25.8%. This is due to the checkerboard geometry, which, as can be seen in from Figure 6A, results in a diffraction efficiency plot where, with the exception of the $(-1, 0)$th, $(0, 0)$th and $(1, 0)$th order diffraction beams, moving in the shearing direction, every other diffraction beam has a diffraction efficiency of 0%. That is, the grating efficiencies of the $(n, m)$th diffraction orders wherein $n \pm m$ is an even number are all zero, except the $(0, 0)$th diffraction order. As a result of these grating efficiencies being zero, all of the interference strengths which contribute to the first harmonic of the phase stepping signal are zero except for interference strengths $\gamma_{-1,0}$ and $\gamma_{0,+1}$.

The portion of the radiation detector 23 that corresponds to the numerical aperture of the projection system PS (represented by circle 40 in Figures 7A to 11B) may be considered to comprise three sections, each distinguished by the interference beams that contribute to the first harmonic of the oscillating phase-stepping signal in these sections. These three sections may be considered to be: a first crescent moon-shaped section to which only the interference beam with interference strength $\gamma_{-1,0}$ contributes; a second crescent moon-shaped section to which only the interference beam with interference strength $\gamma_{0,+1}$ contributes; and central portion to which both of these interference beams contributes. The first crescent moon-shaped section is the white portion shown in Figure 11B; the second crescent moon-shaped section is the white portion shown in Figure 11A; and the central portion is the overlap between the two regions 41, 42. The central portion, which is the overlap between the two regions 41, 42, may be referred to as the three-beam region of the radiation detector 23.

For the overlap between the two regions 41, 42 shown in Figures 11A and 11B (this overlap region will form the majority of circle 40 for small shearing angles) the first harmonic of the oscillating phase-stepping signal will be proportional to the sum of two cosines (cf. equation (2) and expression (3)):

$$(4)$$

$$I = DC + \gamma_{-1,0}\cos(W_{-1} - W_0) + \gamma_{0,+1}\cos(W_0 - W_{+1})$$

where the first cosine is of a difference in the aberration map between a first two points in the pupil plane and the second cosine is of a difference in the aberration map between a second two points in the pupil plane (here the phase stepping terms have been omitted for clarity of understanding). In particular, for a given position (x, y) on the radiation detector (x referring to the shearing direction), the first two points include a corresponding point in the pupil plane (x, y) (represented as $W_0$ in equation (4)) and another point which is shifted in a first direction along the shearing direction by the shearing distance (x-s, y) (represented as $W_{-1}$ in equation (4)). Similarly, the second two points include a corresponding point in the pupil plane (x, y) (represented as $W_0$ in equation (4)) and another point which is shifted in a second direction along the shearing direction by the shearing distance (x+s, y) (represented as $W_{+1}$ in equation (4)).

Existing wavefront reconstruction techniques exploit the fact that the two interference strengths in equation (4) are equal such that this sum of two cosines can be re-written using trigonometric identities as a cosine of half the difference in the aberration map between two positions that are separated in the shearing direction by twice the shearing distance, i.e. $\cos(\frac{1}{2}(W_{-1} - W_{+1}))$, multiplied by a factor that is approximately 1 for small shearing distances. Therefore, such known techniques involve the determination of a set of Zernike coefficients by equating the phase of the first harmonic of a phase stepping signal (within the overlap between the two regions 41, 42) to half of the difference in the aberration map between positions in the pupil plane that are separated in the shearing direction by twice the shearing distance. Optionally, in the first and second crescent moon-shaped sections the phase of the first harmonic of a phase stepping signal may be equated to the difference in the aberration map between positions in the pupil plane that are separated in the shearing direction by the shearing distance. However, as noted above, since the overlap between the two regions 41, 42 shown in Figures 11A and 11B forms the majority of circle 40 for small shearing angles, some existing reconstruction algorithms only use the overlap between the two regions 41, 42 (and does not use the first and second crescent moon-shaped sections of the radiation detector 23). Recall that the aberration map depends on the Zernike coefficients (see equation (1)). This is done for a plurality of positions on the radiation sensor (for example at a plurality of pixels or individual sensing elements in an array) first for a first shearing direction and then subsequently for a second, orthogonal direction. These constraints for the two shearing orthogonal directions are simultaneously solved to find the set of Zernike coefficients.

As discussed above, the combination of a first patterned region 31 comprising a linear grating and a second patterned region 32 comprising a two-dimensional checkerboard is advantageous (since only two interference beams contribute to the first harmonic of the phase stepping signal). Due to the geometry of the checkerboard, checkerboard gratings typically comprise an optical transmissive carrier or support layer. However, EUV radiation is strongly absorbed by most materials and therefore no good transmissive materials exist for EUV radiation. Furthermore, such a transmissive carrier is not favourable in a wafer production environment of an EUV lithographic system, since the transmissive carrier will rapidly become contaminated in such an environment. This would render the transmissive carrier untransmissive for EUV. Such contamination problems which could only be addressed by regular cleaning actions that would impact system availability and therefore the throughput of the lithographic system. For the above-mentioned reasons a checkerboard grating arrangement is difficult to implement for lithographic systems that use EUV radiation.

For this reason, existing aberration measurement systems for EUV radiation use, as a second patterned device 32, a geometry which uses an array of circular pinholes. Figure 12 shows the unit cell 50 of such a grating, having a 50% (by area) duty cycle. The unit cell 50 comprises a circular aperture 51 provided in an EUV absorbing membrane 52. The circular aperture 51 is a through aperture which represents a void in the EUV absorbing membrane 52 through which EUV radiation is transmitted. In order to achieve a 50% (by area) duty cycle, the ratio of the radius $r$ of the aperture 51 to the pitch $p$ of the grating (i.e. the distance between the centres of adjacent apertures) is given by:

$$(5)$$

$$\frac{r}{p} = \sqrt{\frac{1}{2\pi}}$$

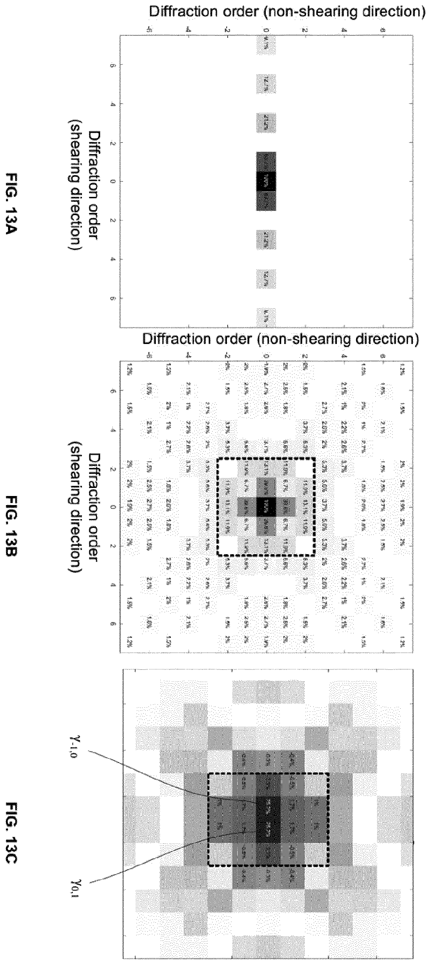

which is approximately 0.4. However, such a pinhole array geometry (as shown in Figure 12) generates unwanted interference beams that contribute to the first harmonic of the phase stepping signal, as now discussed with reference to Figures 13A-13B.

Figure 13A shows the scattering efficiency for a first patterned region 31 that is of the form of the first portion 15a' of the patterned region 15a shown in Figure 3A, having a 50% duty cycle (of the same geometry as that shown in Figure 6A). Again, the diffraction efficiencies are normalised to the efficiency of a $0^{th}$ order diffraction beam, such that the efficiency of the $0^{th}$ order diffraction beam is 100%. Figure 13B shows the scattering efficiency for a second patterned region 32 that is of the form of a pinhole array having the unit cell 50 shown in Figure 12. The diffraction efficiencies shown in Figure 13B are normalised to the efficiency of the $(0, 0)^{th}$ order diffraction beam, such that the efficiency of the $(0, 0)^{th}$ order diffraction beam is 100%.

Figure 13C is a plot of the interference strengths $\gamma_{n,n+1}$ for interference beams that contribute to the first harmonic of the oscillating phase-stepping signal (this is constructed from the scattering efficiencies of Figures 13A and 13B in an analogous manner to the construction of Figure 6C from the scattering efficiencies of Figures 6A and 6B).

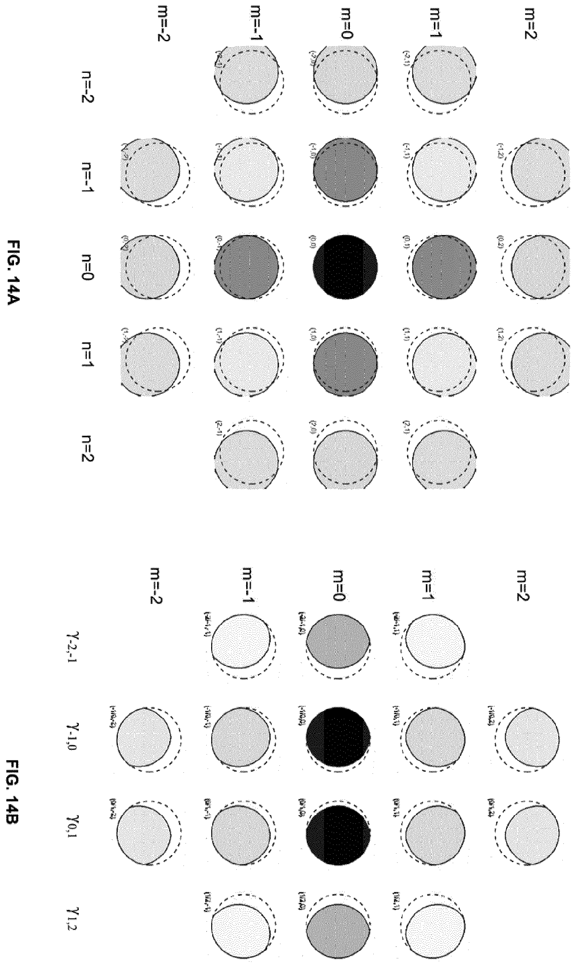

It can be seen from Figure 13C that with a second patterned region 32 which has the unit cell 50 shown in Figure 12, in addition to the two main interference beams (with interference strengths $\gamma_{-1,0}$, $\gamma_{0,+1}$ of 25.2%), there are a number of additional interference beams with small, but non-zero, interference strengths $\gamma_{n,n+1}$. Furthermore, each of the interference beams has a different overlap at the radiation detector 23 with the circular portion of the radiation detector 23 that corresponds to the numerical aperture of the projection system PS, as now discussed with reference to Figures 14A and 14B.

Figure 14A is a representation of 21 second diffraction beams generated by a second patterned region 32 having a unit cell 50 as shown in Figure 12. In particular, these may be considered to be the second diffraction beams generated by such a second patterned region 32 and originating from the $0^{th}$ order first diffraction beam 35. Figure 14A shows the diffraction efficiencies of these second diffraction beams and these correspond to the diffraction efficiencies contained within the dotted line in Figure 13B. Actually the dotted line in Figure 13B corresponds to 25 second diffraction beams, however, the diffraction efficiencies for 4 of these are negligible and therefore they have not been included on Figure 14A. In addition, in Figure 14A a dashed circular line indicates a region on the radiation detector 23 which corresponds to the numerical aperture of the projection system PS.

Figure 14B is a representation of 16 interference beams, each generated by the interference of pairs of the second diffraction beams shown in Figure 14A with second diffraction beams generated by this second patterned region 32 and originating from the $\pm 1^{st}$ order first diffraction beams 34, 36. Figure 14B shows the interference strengths of these interference beams and these correspond to the interference strengths contained within the dotted line in Figure 13C. Again, the dotted line in Figure 13C actually corresponds to 20 different second diffraction beams, however, the interference strengths for 4 of these are negligible and therefore they have not been included on Figure 14B. In addition, in Figure 14B a dashed circular line indicates a region on the radiation detector 23 which corresponds to the numerical aperture of the projection system PS.

It can be seen from Figures 13C and 14B that with a second patterned region 32 which has the unit cell 50 shown in Figure 12, in addition to the two main interference beams (with interference strengths $\gamma_{-1,0}$, $\gamma_{0,+1}$ of 25.2%), there are a number of additional interference beams with small, but non-zero, interference strengths $\gamma_{n,n+1}$. Since the interference strengths for these additional interference beams are not the same, for regions of the radiation detector 23 where multiple interference beams overlap, the first harmonic of the oscillating phase-stepping signal will be proportional to a weighted sum of a plurality of cosines (cf. equation (4)), the cosines having different weights. As a result, they cannot be combined easily using trigonometric identities. However, since the interference strengths $\gamma_{n,n+1}$ for the additional interference beams are small (in comparison to the interference strengths $\gamma_{-1,0}$, $\gamma_{0,+1}$), typically, known existing aberration measurement systems for EUV radiation neglect these terms (i.e. assume they are zero) in the reconstruction of the wavefront to find the set of Zernike coefficients.

This assumption impacts the accuracy of the wavefront measurement. In turn, this has a negative impact on system imaging, overlay and focus performance. Embodiments of the present invention have been devised to at least partially address the above-described problems for aberration measurement systems for EUV radiation.

Embodiments of the present invention relate to new and alternative solutions that are proposed to address the problems caused by the presence of additional interference beams (in addition to the two main interference beams that have interference strengths $\gamma_{-1,0}$, $\gamma_{0,+1}$). In particular, some embodiments of the present invention relate to new and alternative two-dimensional diffraction gratings for use as the second patterned region 32.

One solution that has been proposed to address the problems caused by the presence of additional interference beams (in addition to the two main interference beams (with interference strengths $\gamma_{-1,0}$, $\gamma_{0,+1}$) is to use two-dimensional diffraction gratings for the second patterned region 32 that are have a specific geometry.

In a first example, it was suggested that for the second patterned region 32, an array of square apertures be used (with the axes of the array rotated relative to the shearing direction by an angle of 45°). In particular, it was previously taught that each of the square apertures should have a length that is half the distance between the centres of adjacent apertures. It was found that such an arrangement was particularly beneficial since it could provide a self-supporting grating that resulted in only four contributions to the first harmonic of the phase stepping signal, all having an equal intensity.

In the alternative, it was proposed that for the second patterned region 32 a grating should be used which has the unit cell that is generally of the form of the unit cell 50 shown in Figure 12, but wherein a ratio of the radius r of the aperture 51 to the pitch p of the grating (i.e. the distance between the centres of adjacent apertures) is varied from the nominal value of -0.4 given by equation (5). In particular, it was suggested that the diameter and the spacing of the apertures of a pinhole array be selected so as to reduce the total number of interference beams that contribute significantly (for example with an interference strength above a threshold value) to the first harmonic of the phase stepping signal. For example, in one known solution to the above problem, it was proposed that rather than selecting a ratio of the radius of the circular apertures to the distance between the centres of adjacent apertures of -0.4 (to achieve a duty cycle of 50% by area), the ratio of the radius of the circular apertures to the distance between the centres of adjacent apertures should be selected to be either 0.3 or 0.43. In a first example, a grating wherein the ratio of the radius of the apertures to the distance between the centres of adjacent apertures is approximately 0.3 was selected to suppress, or minimise, the $(\pm 2, 0)$ and $(0, \pm 2)$ diffraction orders of the pinhole grating (which are both zero for a perfect checkerboard grating). It was found that this ratio was beneficial for the reconstruction of the aberration map (relative to the nominal value of -0.4). In a second example, a grating wherein the ratio of the radius of the apertures to the distance between the centres of adjacent apertures is approximately 0.43 was selected to suppress, or minimise, the $(\pm 1, \pm 1)$ diffraction orders (which are zero for a perfect checkerboard grating). Again, it was found that this ratio was beneficial for the reconstruction of the aberration map (relative to the nominal value of -0.4).

A grating which has a unit cell that is generally of the form of the unit cell 50 shown in Figure 12 may be referred to as a pinhole array.

Contrary to these teachings, the inventors of the present invention have found that better pinhole array geometries can be selected. In particular, although it is desirable to reduce the number of contributions to the first harmonic of the phase stepping signal, the inventors have found that it is better to select a geometry of the wafer level grating (i.e. the second patterned region 32) based on gain and cross-talk errors of the reconstruction algorithm, as now discussed.

The inventors have realised that the errors in the aberration map reconstruction can be better controlled in the following way. A wavefront aberration map represents the distortions of the wavefront of light approaching a point in an image plane of the projection system from a spherical wavefront and can be expressed as a linear combination of Zernike polynomials (see equation (1)). It is possible to input a pure Zernike wavefront aberration map (for example $Z_n$) into a reconstruction algorithm and to assess how the reconstruction algorithm reconstructs this as a linear combination of Zernike polynomials. Ideally, the reconstruction algorithm should output a set of Zernike coefficients $c_m$ such that $c_m = 1$ for m = n and $c_m = 0$ for m ≠ n. Any variation of $c_n$ from 1 may be referred to as a gain error. Furthermore, any variation of $c_m$ from 0 where m ≠ n may be referred to as a cross-talk error.

In general, if a projection system has an aberration map that can be described by a vector of Zernike coefficients, $c_{actual}$, then the a vector of Zernike coefficients, $c_{reconstructed}$, reconstructed by a reconstructions algorithm may be is given by:

$$(6)$$

$$c_{reconstructed} = M \cdot c_{actual}$$

where M is a matrix containing the gain errors and cross-talk errors of the reconstruction. In particular, the diagonal elements of the matrix M should ideally be 1 and the off-diagonal element are the cross-talk errors (and should ideally be zero). Therefore, ideally, matrix M should be the identity matrix, which would represent a perfect reconstruction. An error matrix E can be defined by:

$$(7)$$

$$E = M - I$$

where I is the identity matrix. The diagonal elements of the matrix E are the gain errors (and should ideally be zero) and the off-diagonal element are the cross-talk errors (and should ideally be zero). Matrix E therefore represents a good figure of merit for assessing the errors in the aberration map reconstruction, as now discussed.

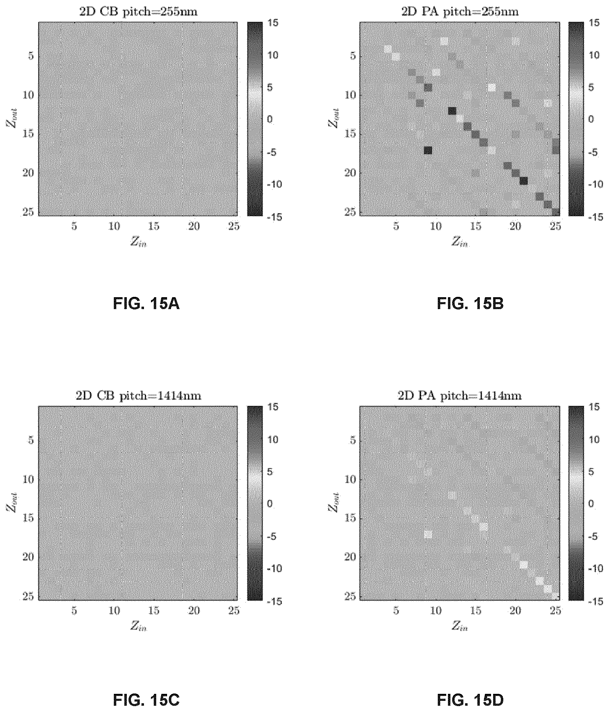

It has been found from a 2 dimensional simulation that for an aberration map measurement system using a one dimensional diffraction grating at reticle level (i.e. the first patterned region 31) with a duty cycle of 50% and a pinhole array grating at wafer level that a global reduction in the gain errors and the cross-talk errors of the order of a factor of 2 may be obtained using a ratio of the radius of the circular pinhole apertures to the distance between the centres of adjacent apertures of around 0.36 (relative to the nominal value of 0.4). Furthermore, it has been found from this 2 dimensional simulation that a global reduction in the gain errors and the cross-talk errors is also achieved relative to the previously suggested optimised value of 0.3. This is now discussed with reference to Figures 15A to 20E.

Figures 15A to 15D show plots of the elements of the error matrix E as defined by equation (7) as percentage errors. In Figures 15A to 15D the actual Zernike coefficients, $c_{actual}$, correspond to the axis labelled $Z_{in}$ and the reconstructed Zernike coefficients, $c_{reconstructed}$, correspond to the axis labelled $Z_{out}$. Figures 15A and 15B show the error matrix E for the first 25 Zernike coefficients for gratings having a pitch of 255 nm whereas 15C and 15D show the error matrix E for the first 25 Zernike coefficients for gratings having a pitch of 1414 nm. Figures 15A and 15C represent the error matrix E for a checkerboard grating whereas Figures 15B and 15D represent the error matrix E for a pinhole grating having the nominal ratio of radius to pitch (see equation 5) of -0.4. It can be seen from Figures 15A to 15D that the error matrix for a checkerboard grating (see Figures 15A and 15C) are vanishingly small whereas at least some elements of the error matrix for a pinhole array with the nominal ratio of radius to pitch (see Figures 15B and 15D) are significantly larger.

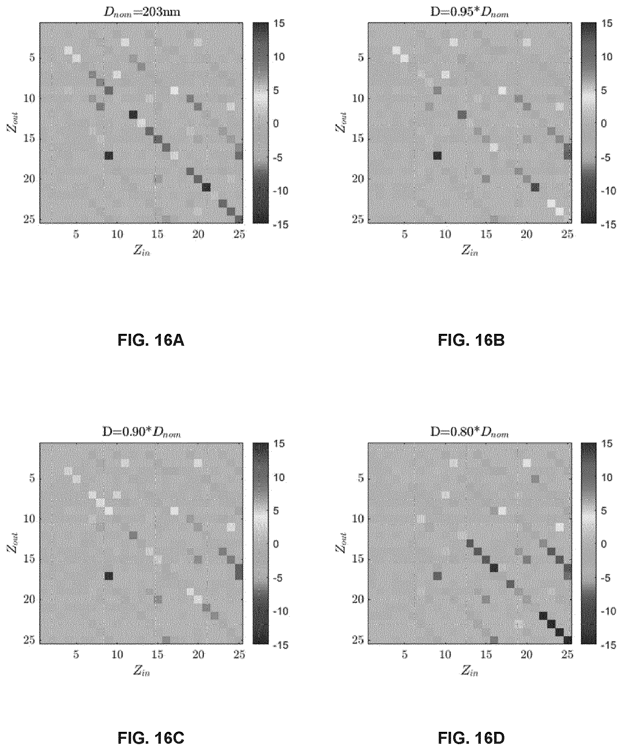

Figures 16A to 16D show plots of the elements of the error matrix E as defined by equation (7) as percentage errors for the first 25 Zernike coefficients and for gratings having a pitch of 255 nm. In Figures 16A to 16D the actual Zernike coefficients, $c_{actual}$, correspond to the axis labelled $Z_{in}$ and the reconstructed Zernike coefficients, $c_{reconstructed}$, correspond to the axis labelled $Z_{out}$. Each of Figures 16A to 16D represents the error matrix E for a pinhole grating having a different ratio of radius to pitch. In particular, Figure 16A represents a pinhole grating having the nominal ratio of radius to pitch of -0.4 (and is therefore identical to Figure 15B); Figure 16B represents a pinhole grating having 0.95 times the nominal ratio of radius to pitch; Figure 16C represents a pinhole grating having 0.9 times the nominal ratio of radius to pitch; and Figure 16D represents a pinhole grating having 0.8 times the nominal ratio of radius to pitch. It can be seen from Figures 16A to 16D that elements of the error matrix E are generally smallest for a pinhole grating having 0.9 times the nominal ratio of radius to pitch.

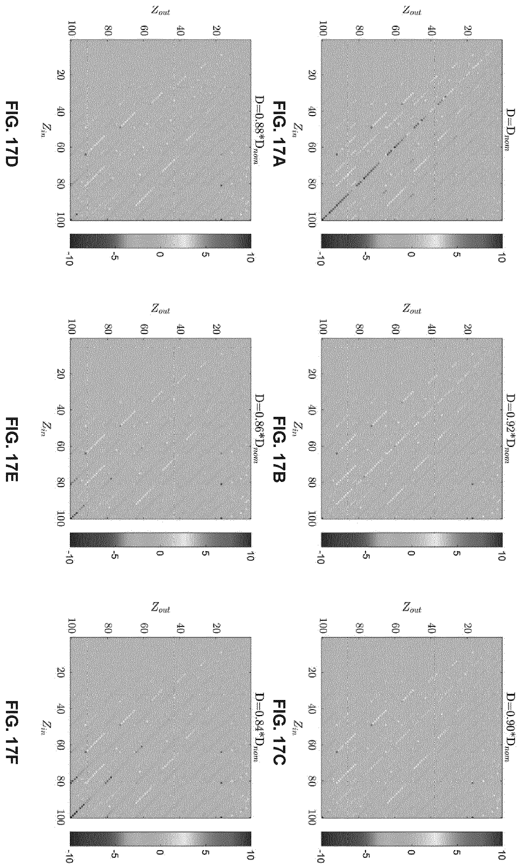

Figures 17A to 17F show plots of the elements of the error matrix E as defined by equation (7) as percentage errors the first 100 Zernike coefficients and for gratings having a pitch of 1414 nm. Each of Figures 17A to 17F represents the error matrix E for a pinhole grating having a different ratio of radius to pitch. In particular, Figure 17A represents a pinhole grating having the nominal ratio of radius to pitch of -0.4 (and is therefore an enlarged view of the matrix shown in Figure 15D); Figure 17B represents a pinhole grating having 0.92 times the nominal ratio of radius to pitch; Figure 17C represents a pinhole grating having 0.9 times the nominal ratio of radius to pitch; Figure 17D represents a pinhole grating having 0.88 times the nominal ratio of radius to pitch; Figure 17E represents a pinhole grating having 0.86 times the nominal ratio of radius to pitch; and Figure 17F represents a pinhole grating having 0.84 times the nominal ratio of radius to pitch. It can be seen from Figures 17A to 17F that elements of the error matrix E are generally smallest for a pinhole grating having 0.88 to 0.92 times the nominal ratio of radius to pitch, with a pinhole grating having 0.9 times the nominal ratio of radius to pitch providing a significant improvement over a pinhole grating having the nominal ratio of radius to pitch.

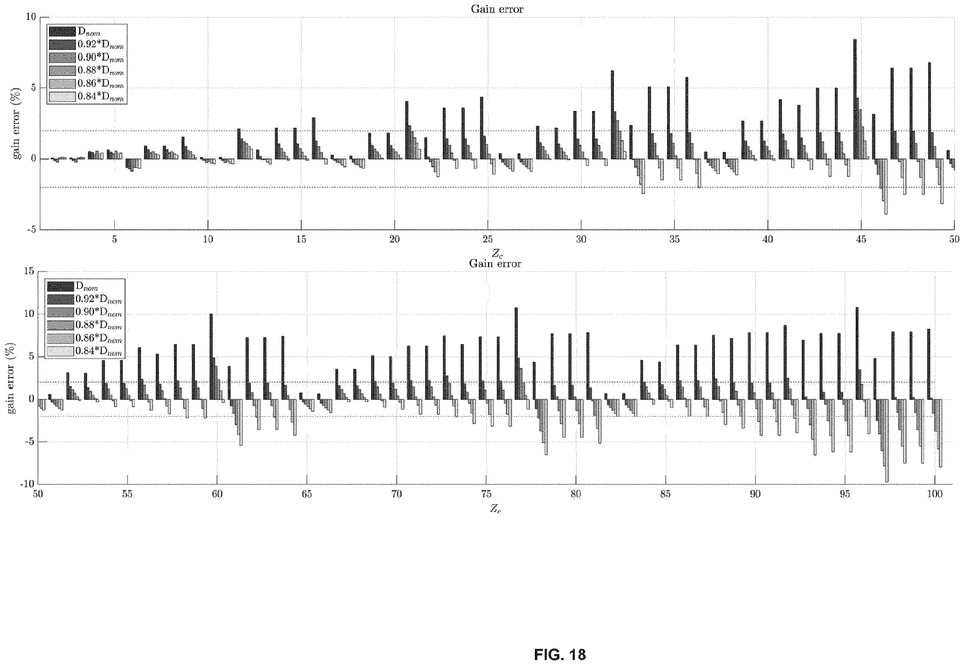

Figure 18 shows the gain errors (i.e. the diagonal elements of the error matrix E as defined by equation (7) as percentage errors for the first 100 Zernike coefficients and for gratings having a pitch of 1414 nm for a range of different ratios of radius to pitch. In particular, Figure 18 shows the gain errors for the different ratios of radius to pitch shown in Figures 17A to 17F (i.e. Figure 18 represents the diagonal elements of all of the error matrices E shown in Figures 17A to 17F). It can be seen from Figure 18 that the gain errors are generally smallest for a pinhole grating having 0.88 to 0.92 times the nominal ratio of radius to pitch, with a pinhole grating having 0.9 times the nominal ratio of radius to pitch providing a significant improvement over a pinhole grating having the nominal ratio of radius to pitch.

The actual error in a reconstructed aberration map is dependent on both the reconstruction errors (i.e. the gain errors and the cross-talk errors) and the aberrations experienced by the projection system PS being analysed. Therefore, it may be desirable to minimize particular elements of the error matrices E at the expense of other elements being slightly larger. For example, for a projection system that is prone to relatively large $Z_i$ aberrations and relatively low $Z_j$ aberrations may in practice perform better using a ratio of the radius of the circular pinhole apertures to the distance between the centres of adjacent apertures that minimise the gain errors and the cross-talk errors for $Z_i$ aberrations, even if there is an increase in the gain errors and the cross-talk errors for $Z_j$ aberrations. It may be particularly desirable to optimize a value of the ratio of radius to pitch for a pinhole array with particular attention to the first n Zernike orders. For example, it may be particularly desirable to optimize a value of the ratio of radius to pitch for a pinhole array with particular attention to the first 25 Zernike orders.

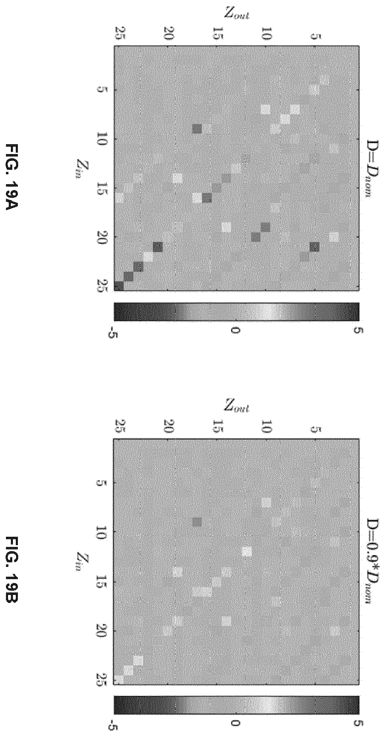

Figures 19A and 19B show plots of the elements of the error matrix E as defined by equation (7) as percentage errors for the first 25 Zernike coefficients and for gratings having a pitch of 1414 nm. Figure 19A represents the error matrix E for a pinhole grating having the nominal ratio of radius to pitch of -0.4 (and is therefore an enlarged portion of Figure 17A); and Figure 19B represents the error matrix E for a pinhole grating having 0.9 times the nominal ratio of radius to pitch (and is therefore an enlarged portion of Figure 17C). It can be seen from Figures 19A and 19B that a pinhole grating having 0.9 times the nominal ratio of radius to pitch (see Figure 19B) provides a significant reduction in the gain and cross-talk errors over a pinhole grating having the nominal ratio of radius to pitch for the first 25 Zernike orders.

In some embodiments, the ratio of the radius of the circular apertures to the distance between the centres of adjacent apertures is close to an optimum value that results in a minimization of the gain and cross-talk errors. For example, this optimization may be for a situation when the diffraction grating is used as a wafer level patterning device (i.e. as second patterned region 32) of a phase-stepping measurement system for determining an aberration map for a projection system in combination with a reticle level patterning device (i.e. first patterned region 31) that comprises a one-dimensional diffraction grating with a 50% duty cycle. The reconstruction algorithm of the phase-stepping measurement system may assume that the grating is of the form of a checkerboard grating.

In some embodiments the pinhole array has a ratio of the radius of the circular apertures to the distance between the centres of adjacent apertures between 0.36 and 0.38. In some embodiments the pinhole array has a ratio of the radius of the circular apertures to the distance between the centres of adjacent apertures between 0.35 and 0.37. In some embodiments the pinhole array has a ratio of the radius of the circular apertures to the distance between the centres of adjacent apertures of approximately 0.36.

It is believed that as the ratio of the radius of the circular pinhole apertures to the distance between the centres of adjacent apertures is reduced from the nominal value of 0.4 the gain errors and the cross-talk errors reduce up to a point and thereafter the gain errors and the cross-talk errors start to increase again as this ratio tends to the previously proposed value of 0.3.

Therefore, it is believed that in the range of 0.34 to 0.38 a reduction in the gain errors and the cross-talk errors is achieved relative to the two previously disclosed values of 0.3 and 0.4.

The optimization of the value of the ratio of the radius of the circular pinhole apertures to the distance between the centres of adjacent apertures is difficult for two reasons.

First, the actual error in a reconstructed aberration map is dependent on both the reconstruction errors (i.e. the gain errors and the cross-talk errors) and the aberrations experienced by the projection system PS being analysed. For example, for a projection system that is prone to relatively large $Z_i$ aberrations and relatively low $Z_j$ aberrations may in practice perform better using a ratio of the radius of the circular pinhole apertures to the distance between the centres of adjacent apertures that minimise the gain errors and the cross-talk errors for $Z_i$ aberrations, even if there is an increase in the gain errors and the cross-talk errors for $Z_j$ aberrations.

Second, the simulation should take into account the fact that the diffraction grating is three-dimensional, which means that the grating will not be a perfect binary grating. For example, due to the finite, non-zero thickness of the grating, radiation incident on the substrate in-between the apertures will, in general, not be perfectly absorbed. In addition, in use, radiation may be incident on the grating at a range of angles. As a result, at least some of the radiation that is incident on the membrane (for example at a large angle of incidence and close to one of the through apertures) will propagate through a distance in the membrane that is only a small fraction of the thickness of the membrane and will therefore not be fully attenuated. Furthermore, in general, there may be a difference in refractive index between the substrate and the surrounding medium (which will be in the through-apertures). As a result, there will be a phase difference induced between the radiation that propagates through the membrane and the radiation that does not (due to the different optical path lengths experienced).

It is thought that taking into account such 3 dimensional effects, there may be a small shift in the optimum ratio of the radius of the circular pinhole apertures to the distance between the centres of adjacent apertures of around, which may be dependent on the optical properties of the material from which the grating is formed and the thickness of the membrane. However, it is thought that this optimum ratio will lie in the range of 0.34 to 0.38.

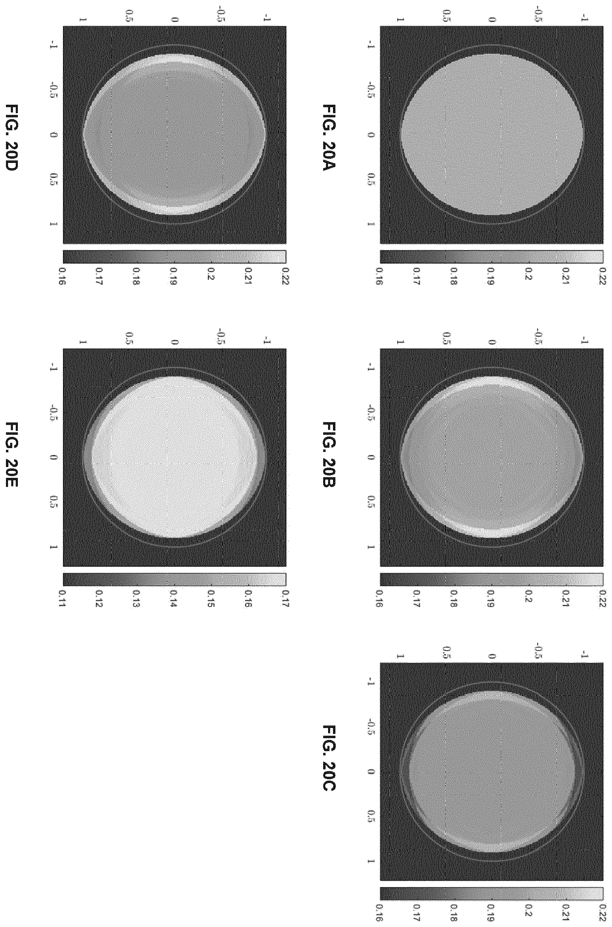

Another type of optimization that may be considered for selecting a suitable ratio of the radius of the circular apertures to the distance between the centres of adjacent apertures is now discussed with reference to Figures 20A to 20E. Each of Figures 20A to 20E shows an interference beam map for a different geometry of diffraction grating of the second patterned region 32.

A definition of the interference beam map and how it may be determined is now discussed.

The interference beam map is defined in a measurement plane. The measurement plane may correspond to a plane of the radiation detector 23 of a phase-stepping measurement system. Specifically, it is defined for an overlap in this measurement plane between: first and second diffraction beams that result from the $0^{th}$ order diffraction beam 35 from the reticle level patterning device (i.e. first patterned region 31) illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

It will be appreciated that the central first diffraction beam 35 (which corresponds to a $0^{th}$ order diffraction beam of first patterned region 31) illuminates the second patterned region 32 generally telecentrically. It will be appreciated that as used here telecentric illumination of an object is intended to mean that the energy centroid of the radiation incident on the object is generally normal to a plane of the object. For example, the incident radiation may generally be of the form of a converging cone of radiation and an axis of that cone may be generally normal to a plane of the object. In contrast, the first diffraction beams 34, 36 (which correspond to the $\pm 1^{st}$ order diffraction beams of first patterned region 31) illuminate the second patterned region 32 non-telecentrically.

Since the central first diffraction beam 35 illuminates the second patterned region 32 generally telecentrically, the two second diffraction beams 35b, 35c (which correspond to the $\pm 1^{st}$ order diffraction beams) may be considered to be first and second diffraction beams that would be formed by telecentric illumination. The first diffraction beam is the $+1^{st}$ order diffraction beam in a shearing direction and the $0^{th}$ order diffraction beam in a non-shearing direction and the second diffraction beam is the $-1^{st}$ order diffraction beam in a shearing direction and the $0^{th}$ order diffraction beam in a non-shearing direction.

The overlap in this measurement plane between these first and second diffraction beams corresponds to a central portion of the radiation detector 23 to which both the interference beam with interference strength $\gamma_{-1,0}$ and the interference beam with interference strength $\gamma_{0,+1}$ contributes. That is, the overlap in this measurement plane between these first and second diffraction beams corresponds to the overlap between the two regions 41, 42 shown in Figures 11A and 11B.

A value of the interference beam map at a given position in the measurement plane is given by a magnitude of a sum of contributions from all of the interference beams which contribute to the first harmonic of the oscillating phase-stepping signal and which overlap with that position in the measurement plane, as now discussed. In particular, the interference beam map is given by a magnitude of a sum of contributions from all of the interference beams which contribute to the first harmonic of the oscillating phase-stepping signal when the diffraction grating is used as a wafer level patterning device (i.e. as the second patterned region 32) of a phase-stepping measurement system for determining an aberration map for a projection system in combination with a reticle level patterning device (i.e. the first patterned region 31) that comprises a one-dimensional diffraction grating with a 50% duty cycle.

In general, for a given region of the radiation detector 23 multiple interference beams overlap and therefore the first harmonic of the oscillating phase-stepping signal will be proportional to a weighted sum of a plurality of cosines (cf. equation (4)), the cosines having different weights. Each of these cosines has the same dependence on the relative positions of the first and second patterned regions 31, 32 in the shearing direction (cf. equation (3), where v parameterizes the relative positions of the first and second patterned regions 31, 32 in the shearing direction) and can therefore be combined as the addition of a plurality of phasors, as now explained.

In particular, the first harmonic of the phase stepping signal for a given position on the radiation detector 23 (for example a given sensing element or pixel) can be written as:

$$(8)$$

$$M \cos\left(\frac{2\pi}{p} \cdot v + \Delta W\right) = \sum_i \gamma_i \cos\left(\frac{2\pi}{p} \cdot v + \Delta W_i\right)$$

where $M$ and $\Delta W$ are, respectively, an amplitude and a phase of the first harmonic of the phase stepping signal, the sum is over all interference beams which overlap with this position on the radiation detector 23 and which contribute to the first harmonic of the oscillating phase-stepping signal, $\gamma_i$ is the interference strength of the ith interference beam and $\Delta W_i$ is a difference between the value of the aberration map at two positions in the pupil plane of the projection system PS, the two positions corresponding to the positions from which the two second diffraction beams that contribute to the ith interference beam originate. Although $M$ is the amplitude of the first harmonic of the phase stepping signal, it may alternatively be referred to as the modulation.

The interference map is a map of the amplitude of the first harmonic of the phase stepping signal $M$ that would result from a perfect system with zero aberrations. It will be appreciated that, in general, the amplitude of the first harmonic of the phase stepping signal, $M$, at a given position in the measurement plane will be dependent on the set of interference strengths $\{\gamma_i\}$ and the set of differences $\{\Delta W_i\}$ of all of the interference beams which contribute to the first harmonic of the oscillating phase-stepping signal and which overlap with that position in the measurement plane in equation (8).

When a checkerboard grating is used as the wafer level patterning device of a phase-stepping measurement system for determining an aberration map, the interference beam map in a region that corresponds to an overlap in a measurement plane between the first and second diffraction beams is uniform. This is because across the whole of this region of the measurement plane there are exactly two diffraction beams which contribute to the first harmonic of the oscillating phase-stepping signal and these have equal interference strengths (the interference beam with interference

strength $\gamma_{-1,0}$ and the interference beam with interference strength $\gamma_{0,+1}$). Figure 20A shows the interference beam map for a checkerboard grating being used as the second patterned region 32.

However, when a pinhole array geometry is used for the wafer level patterning device this generates unwanted interference beams that contribute to the first harmonic of the phase stepping signal. In particular, in addition to the two contributions that are present with a checkerboard grating, there are a large number of additional interference beams with small, but non-zero, intensities at the radiation detector 23. The interference beam map may be formed, for example, by finding the magnitude of the first harmonic of the phase stepping signal at each point on the radiation detector 23 that would result from no aberrations. It will be appreciated that this can be found by combining all of the contributions shown in Figure 14B as discussed above with reference to equation (8). Since each of these contributions has a different position in the measurement plane there will, in general, be some variation in the interference beam map (since different positions will, in general, have different contributions to the first harmonic of the oscillating phase-stepping signal). Furthermore, in general, the additional, unwanted interference beams may increase or decrease the magnitude of the first harmonic of the phase stepping signal.

Figure 20B shows the interference beam map for a pinhole array being used as the second patterned region 32, the grating having a pitch of 255 nm and the nominal ratio of radius to pitch of -0.4. Figure 20C shows the interference beam map for a pinhole array being used as the second patterned region 32, the grating having a pitch of 255 nm and having 0.9 times the nominal ratio of radius to pitch (i.e. a ratio of radius to pitch of -0.36). Figure 20D shows the interference beam map for a pinhole array being used as the second patterned region 32, the grating having a pitch of 255 nm and having 1.08 times the nominal ratio of radius to pitch (i.e. a ratio of radius to pitch of ∼0.43). Figure 20E shows the interference beam map for a pinhole array being used as the second patterned region 32, the grating having a pitch of 255 nm and having 0.75 times the nominal ratio of radius to pitch (i.e. a ratio of radius to pitch of ∼0.3).

As explained above, in general, the first harmonic of the oscillating phase-stepping signal only depends on the contributions from first diffraction beams (i.e. diffraction beams formed by the reticle level patterning device, i.e. the first patterned region 31) that differ in order by ±1. With a reticle level patterning device (i.e. the first patterned region 31) that comprises a one-dimensional diffraction grating with a 50% duty cycle the only two pairs of first diffraction beams that differ in order by ±1 are the 0th order beam with either the ±1st order beams.

The interference strengths for such interference beams that contribute to the first harmonic of the oscillating phase-stepping signal can be determined as explained above with reference to Figures 6C and 13C.

In some embodiments, the ratio of the radius of the circular apertures to the distance between the centres of adjacent apertures is selected so as to be close to an optimum value that results in a minimization of the variation in an interference beam map in a region that corresponds to an overlap in a measurement plane between: first and second diffraction beams that result from the 0th order diffraction beam 35 from the reticle level patterning device (i.e. first patterned region 31) illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction.

It can be seen from Figures 20B to 20E that, for a pinhole array having a pitch of 255 nm, the interference beam map for 0.9 times the nominal ratio of radius to pitch (i.e. a ratio of radius to pitch of ∼0.36; see Figure 20C) reduces the variation in the interference beam map relative to: the nominal ratio of radius to pitch (i.e. a ratio of radius to pitch of ∼0.4; see Figure 20B); 1.08 times the nominal ratio of radius to pitch (i.e. a ratio of radius to pitch of ∼0.43; see Figure 20D); and 0.75 times the nominal ratio of radius to pitch (i.e. a ratio of radius to pitch of ∼0.3; see Figure 20E).

Some embodiments of the present invention relate to methods of designing a diffraction grating for a phase-stepping measurement system for determining an aberration map for a projection system, wherein the diffraction grating is a pinhole array, the methods comprising: selecting a value of a ratio of the radius of the circular apertures to the distance between the centres of adjacent apertures that substantially minimises errors in a reconstruction of the aberration map.

In some embodiments, the ratio of the radius of the circular apertures to the distance between the centres of adjacent apertures may be selected so as to substantially minimize gain and cross-talk errors when the diffraction grating is used as a wafer level patterning device (i.e. second patterned region 32) of a phase-stepping measurement system for determining an aberration map for a projection system. For example, this minimization may be when used in combination with a reticle level patterning device (i.e. first patterned region 31) that comprises a one-dimensional diffraction grating with a 50% duty cycle. For example, a reconstruction algorithm of the phase-stepping measurement system may assume that the grating is of the form of a checkerboard grating.

In some embodiments, the ratio of the radius of the circular apertures to the distance between the centres of adjacent apertures is selected so as to substantially minimize a variation in an interference beam map in a region that corresponds to an overlap in a measurement plane between: first and second diffraction beams that result from the 0th order diffraction beam 35 from the reticle level patterning device (i.e. first patterned region 31) illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction; and wherein a value of the interference beam map at a given position in the measurement plane is given by a sum of the interference strengths of all of the interference beams which contribute to the first harmonic of the oscillating phase-stepping signal and which have a different overlap in the measurement plane when the diffraction grating is used as a wafer level patterning device of a phase-stepping measurement system for determining an aberration map for a projection system in combination with a reticle level patterning device that comprises a one-dimensional diffraction grating with a 50% duty cycle and which overlap with that position in the measurement plane.

Some embodiments of the present invention relate to a diffraction grating having a unit cell that is generally of the form of the unit cell 50 shown in Figure 12, but wherein the circular through-apertures 51 are distributed such that a distance between the centres of adj acent apertures is non-uniform and varies across the diffraction grating.

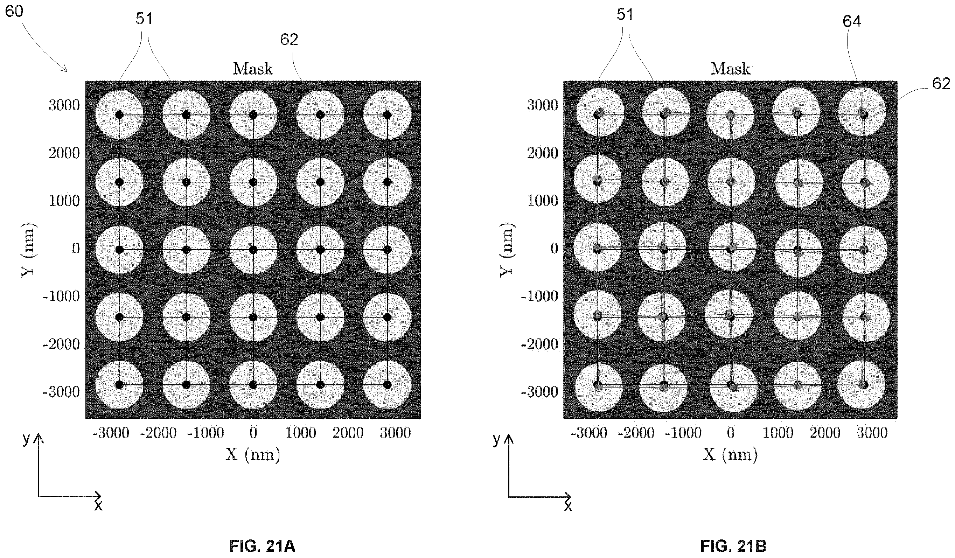

As shown in Figure 21A, typically, a diffraction grating comprises a plurality of apertures 51 that are distributed such that a distance between the centres of adjacent apertures 51 is uniform across the diffraction grating. This is achieved by arranging the apertures 51 such that a centre of each of the circular through-apertures 51 coincides with one of a square array of positions 62. In contrast, as shown in Figure 21B, the diffraction gratings according to some embodiments are formed by arranging the apertures 51 such that a centre 64 of each of the circular through-apertures 51 is proximate to one of a square array of positions 62 but is offset from said one of a square array of positions 62 by an amount which varies across the diffraction grating.

A distance between the centres of adjacent apertures 51 may be referred to as the local pitch of the diffraction grating. The inventors have realised that by introducing local pitch variation, the diffraction grating alters the diffraction pattern. In particular, the inventors have realised that such local pitch variation supresses higher order diffraction beams more than lower order diffraction beams. In turn, advantageously, this reduces the effect of the influence of the additional interference beams (see, for example Figure 14B and the accompanying description) that contribute to the first harmonic of the phase stepping signal that are not present when a two-dimensional checkerboard grating is used.

It has been found from a simulation that for an aberration map measurement system using a one dimensional diffraction grating at reticle level (i.e. first patterned region 31) with a duty cycle of 50% and a pinhole array grating at wafer level that a global reduction in the gain errors and the cross-talk errors of the order of a factor of 2 may be obtained using a randomized pitch variation across the grating.

The distance between the centres 64 of adjacent apertures 51 across the diffraction grating may be random or pseudo-random.

It may be desirable to increase the variation in local pitch so as to increase the suppression of higher order diffraction beams. However, a maximum local pitch variation may be imposed so that the diffraction grating does not rupture and can be tensioned sufficiently to reduce sag of the grating during use without rupturing. For example, it may be desirable to ensure that there will be at least a minimum distance between adjacent apertures. It will be appreciated that a maximum local pitch variation may be dependent on a ratio of the radius of the circular apertures to a nominal distance between the centres of adjacent apertures. For example, for a pinhole array having a ratio of the radius of the circular apertures to a nominal distance between the centres of adjacent apertures of equal to the nominal value of -0.4 (see equation (5)), with no pitch variation a minimum distance between two adjacent apertures is -0.2 times the pitch. If a variation in the distance between the centres 64 of adjacent apertures across the diffraction grating of $\pm$ 10 % of the nominal pitch is introduced then a minimum distance between two adjacent apertures may be in a range of ~0 to ~0.4.

In some embodiments, the variation in the distance between the centres 64 of adjacent apertures across the diffraction grating may be between a nominal distance $\pm$ less than 10 %. In some embodiments, the variation in the distance between the centres of adjacent apertures across the diffraction grating may be between a nominal distance $\pm$ 5 %. That is, the local pitch may vary between 95% and 105% of a nominal pitch.

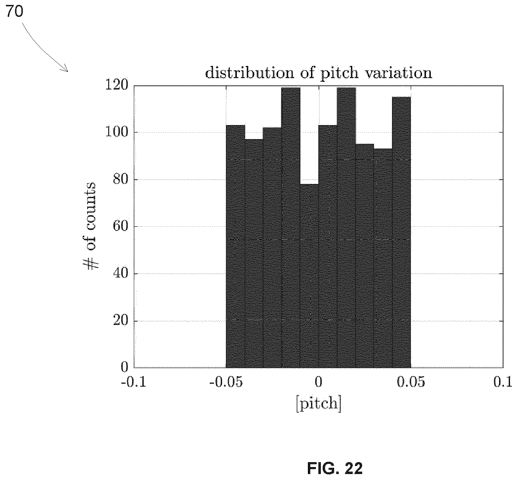

In some embodiments, a distribution of the distance between the centres 64 of adjacent apertures 51 across the diffraction grating is generally uniform between a lower value and a higher value. For example, for a random variation in the distance between the centres of adjacent apertures across the diffraction grating is between a nominal distance $\pm$ 5 %, the lower value may be 95% of a nominal pitch and the higher value may be 105% of a nominal pitch. An example, of such a distribution 70 of the distance between the centres 64 of adjacent apertures 51 across the diffraction grating is shown in Figure 22.

In some embodiments, a distribution of an offset of each of the apertures 51 from a nominal position 62 is generally uniform between a lower value and a higher value.

In some embodiments, a distribution of the offset of each of the apertures 51 from a nominal position 62 in a direction of an axis of the diffraction grating is generally uniform in a first between a lower value and a higher value.

For example, the apertures 51 may be arranged such that a centre of each of the circular through-apertures 51 is proximate to one of a square array of positions 62 and is offset from said one of a square array of positions 62 by an amount which varies across the diffraction grating. The axes of the diffraction grating may be the axes of said square array of positions. The axes of the diffraction grating may be referred to as the x direction and the y direction.

For example, the distribution of offsets $\Delta x$ from the nominal position in an x direction may be uniform and

distribution of offsets $\Delta y$ from the nominal position in an y direction may be uniform.

Some embodiments of the present invention relate to methods of designing a diffraction grating for a phase-stepping measurement system for determining an aberration map for a projection system, wherein the diffraction grating is a pinhole array of the type shown in Figure 21B and described above.

The method may comprise selecting a square array of positions 62 on a membrane. Adjacent positions in the square array may be separated in the two directions parallel to the axes of the square array by a nominal pitch, $p_n$. The method may further comprise selecting a position for an aperture 51 proximate to each one of the square array of positions 62 but offset therefrom as follows. In particular, for each of the square array of positions 62 a first random or pseudo-random number $N_x$ between $\pm |x_{max}|$ and a second random or pseudo-random number $N_y$ between $\pm |y_{max}|$. For example, $x_{max}$ and $y_{max}$ may both be equal to a set fraction of the nominal pitch, for example $0.1 p_n$. The position of each aperture 51 is proximate to one of the square array of positions 62 and is selected such that a centre of the aperture is offset from that position in the square array by a distance of $N_x$ parallel to a first one of the axes of the square array and by a distance of $N_y$ parallel to a first one of the axes of the square array.

Figures 23A to 23D show plots of the elements of the error matrix E as defined by equation (7) as percentage errors for the first 25 Zernike coefficients and for gratings having a nominal pitch of 255 nm. In Figures 23A to 23D the actual Zernike coefficients, $c_{actual}$, correspond to the axis labelled $Z_{in}$ and the reconstructed Zernike coefficients, $c_{reconstructed}$, correspond to the axis labelled $Z_{out}$. Each of Figures 23A to 23C represents the error matrix E for a pinhole grating having a ratio of the radius of the apertures to a nominal distance between the centres of adjacent apertures equal to the nominal value of -0.4 and having a different local pitch variation. In particular, Figure 23A represents a pinhole grating having the a local pitch variation of 0.1 times a nominal pitch; Figure 23B represents a pinhole grating having the a local pitch variation of 0.2 times a nominal pitch; and Figure 23C represents a pinhole grating having the a local pitch variation of 0.3 times a nominal pitch. Figure 23D represents the error matrix E for a pinhole grating having a ratio of the radius of the apertures to a nominal distance between the centres of adjacent apertures equal to 0.9 the nominal value (i.e. -0.36) and having a local pitch variation of 0.1 times the nominal pitch. It can be seen from Figures 23A to 23D that elements of the error matrix E do decrease as the local pitch variation increases. Furthermore, it can be seen from Figure 23D that such local pitch variation can be combined with an optimised ratio of the radius of the apertures to the nominal distance between the centres of adjacent apertures (for example -0.36) to further reduce the elements of the error matrix E (for example by comparing Figures 16A, 16C and 23D).

This additive benefit that can be achieved by co-optimizing: (a) a nominal pitch of the pinhole array; and (b) a local pitch variation can be seen from a consideration of Figures 24A to 24D.

Figures 24A to 24D show plots of the elements of the error matrix E as defined by equation (7) as percentage errors for the first 25 Zernike coefficients and for gratings having a nominal pitch of 1414 nm. In Figures 24A to 24D the actual Zernike coefficients, $c_{actual}$, correspond to the axis labelled $Z_{in}$ and the reconstructed Zernike coefficients, $c_{reconstructed}$, correspond to the axis labelled $Z_{out}$. Figure 24A represents the error matrix E for a pinhole grating having a ratio of the radius of the apertures to a nominal distance between the centres of adjacent apertures equal to the nominal value of -0.4 and having a no local pitch variation (and is therefore identical to Figure 19A). Figure 24B represents the error matrix E for a pinhole grating having a ratio of the radius of the apertures to a nominal distance between the centres of adjacent apertures equal to 0.9 times the nominal value (i.e. a ratio of -0.36) and having a no local pitch variation (and is therefore identical to Figure 19B).

Each of Figures 24C and 24D represents the error matrix E for a pinhole grating having a ratio of the radius of the apertures to a nominal distance between the centres of adjacent apertures equal 0.9 times the nominal value (i.e. a ratio of -0.36) and having a different local pitch variation. In particular, Figure 24C represents a pinhole grating having the a local pitch variation of 0.1 times the nominal pitch; and Figure 24D represents a pinhole grating having the a local pitch variation of 0.2 times the nominal pitch.

In some embodiments, the diffraction gratings discussed above may be self-supporting. In use, the diffraction gratings may be provided with a support for the absorbing layer. The support may only contact a peripheral portion of the absorbing layer. That is, the support may be of the form of a frame and which does is not adjacent to a central portion of the absorbing layer. With such an arrangement, in a central portion of the absorbing layer, the absorbing layer may be considered to be self-supporting. To achieve this, the absorbing layer may be tensioned on the support (for example such that it remains generally planar).

Advantageously, for embodiments wherein the central portion of the absorbing layer is self-supporting, the grating does not need, for example, a transmissive supporting layer. Such an arrangement is particularly beneficial for use in a phase-stepping measurement system for determining an aberration map for a projection system that uses EUV radiation since the use of such a transmissive supporting layer would significantly reduce the amount of EUV radiation that is transmitted by the diffraction grating.

In some embodiments, in the diffraction gratings discussed above, the substrate (in which the apertures are formed) comprises a radiation absorbing layer. The radiation absorbing layer may, for example, be formed from a metal such as, for example, chromium (Cr), nickel (Ni), cobalt (Co) or aluminium (Al).

In some embodiments, the absorbing layer may comprise a ceramic. The ceramic may comprise a metal or metalloid component having a relatively high extinction coefficient for EUV radiation and a non-metal component. Both components may have a refractive index for EUV which is relatively close to 1. The ceramic may comprise aluminium nitride (AlN). In some embodiments, the absorbing layer may comprise aluminium nitride (AlN).

In some embodiments, in the diffraction gratings discussed above, the substrate (in which the apertures are formed) further comprises a support layer. The through-apertures may extend through both the support layer and the radiation absorbing layer. The support layer may, for example, be formed from SiN.

Although the above described embodiments use the first harmonic of the a phase stepping signal it will be appreciated that in alternative embodiments higher harmonics of the phase stepping signal may alternatively be used.

Although the above described embodiments use a first patterned region 31 comprising a one-dimensional diffraction grating 31 with a 50% duty cycle it will be appreciated that in alternative embodiments other the first patterned region 31 may use different geometries. For example, in some embodiments, the first patterned region 31 may comprise a two-dimensional checkerboard diffraction grating with a 50% duty cycle.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Clauses

1. A diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is between 0.34 and 0.38.

2. The diffraction grating of clause 1 wherein the ratio of the radius of the circular apertures to the distance between the centres of adjacent apertures is between 0.35 and 0.37.

3. The diffraction grating of clause 1 or clause 2 wherein the ratio of the radius of the circular apertures to the distance between the centres of adjacent apertures is approximately 0.36.

4. The diffraction grating of any preceding clause wherein the ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

5. The diffraction grating of any preceding clause wherein the ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the 0th order diffraction beam from the reticle level patterning device illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction.

6. A diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

7. A diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the 0th order diffraction beam from the reticle level patterning device illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction.

8. A diffraction grating for a phase-stepping measurement system for determining an aberration map for a projection system, the diffraction grating comprising a substrate provided with a two-dimensional array of circular through-apertures, wherein the circular through-apertures are distributed such that a distance between the centres of adjacent apertures is non-uniform and varies across the diffraction grating.

9. The diffraction grating of clause 8 wherein the variation in the distance between the centres of adjacent apertures across the diffraction grating is random or pseudo-random.

10. The diffraction grating of clause 8 of clause 9 wherein the variation in the distance between the centres of adjacent apertures across the diffraction grating is between a nominal distance ± less than 10 %.

11. The diffraction grating of clause 10 wherein the variation in the distance between the centres of adjacent apertures across the diffraction grating is between a nominal distance ± 5 %.

12. The diffraction grating of any one of clauses 8 to 11 wherein a distribution of the distance between the centres of adjacent apertures across the diffraction grating is generally uniform between a lower value and a higher value.

13. The diffraction grating of any one of clauses 8 to 12 wherein a distribution of an offset of each of the apertures from a nominal position is generally uniform between a lower value and a higher value.

14. The diffraction grating of clause 13 wherein the distribution of the offset of each of the apertures from a nominal position in a direction of an axis of the diffraction grating is generally uniform between a lower value and a higher value.

15. The diffraction grating of any one of clauses 8 to 13, wherein a ratio of the radius of the circular apertures to the distance between the centres of adjacent apertures is between 0.34 and 0.38.

16. The diffraction grating of clause 15, wherein a ratio of the radius of the circular apertures to the distance between the centres of adjacent apertures is between 0.35 and 0.37.

17. The diffraction grating of clause 15 wherein the ratio of the radius of the circular apertures to the distance between the centres of adjacent apertures is approximately 0.36.

18. The diffraction grating of any one of clauses 8 to 17 wherein the ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

19. The diffraction grating of any one of clauses 8 to 18 wherein a ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and wherein the central region in the measurement plane corresponds to an overlap between first and second diffraction beams that result from the 0th order diffraction beam from the reticle level patterning device illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction.

20. The diffraction grating of any preceding clause wherein the diffraction grating is self-supporting.

21. The diffraction grating of any preceding clause wherein the substrate comprises: a radiation absorbing layer.

22. The diffraction grating of clause 21 wherein the substrate further comprises a support layer; and wherein the through-apertures extend through both the support layer and the radiation absorbing layer.

23. A method of designing a diffraction grating for a phase-stepping measurement system for determining an aberration map for a projection system, the diffraction grating comprising a substrate provided with a two-dimensional array of circular through-apertures, the method comprising: selecting a value of a ratio of the radius of the circular apertures to the distance between the centres of adjacent apertures that substantially minimises errors in a reconstruction of the aberration map.

24. The method of clause 23 wherein the ratio of the radius of the circular apertures to the distance between the centres of adjacent apertures is selected so as to substantially minimize gain and cross-talk errors when the diffraction grating is used as a wafer level patterning device of a phase-stepping measurement system for determining an aberration map for a projection system and wherein a reconstruction algorithm of the phase-stepping measurement system assumes that the grating is of the form of a checkerboard grating. optionally, the selection so as to substantially minimize gain and cross-talk errors when the diffraction grating is used as a wafer level patterning device of a phase-stepping measurement system for determining an aberration map for a projection system is for the case where the diffraction gratin is used in combination with a reticle level patterning device that comprises a one-dimensional diffraction grating with a 50% duty cycle.

25. The method of clause 23 or clause 24 wherein the ratio of the radius of the circular apertures to the distance between the centres of adjacent apertures is close to an optimum value that results in a minimization of the variation in an interference beam map in a central region in a measurement plane; wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system for zero aberrations; and wherein the central region in the measurement plane corresponds to an overlap between first and second diffraction beams that result from the 0th order diffraction beam from the reticle level patterning device illuminating the diffraction grating, the first diffraction beam being the +1st order diffraction beam in a shearing direction and the 0th order diffraction beam in a non-shearing direction and the second diffraction beam being the -1st order diffraction beam in a shearing direction and the 0th order diffraction beam in a non-shearing direction.

26. A method of designing a diffraction grating for a phase-stepping measurement system for determining an aberration map for a projection system, the diffraction grating comprising a substrate provided with a two-dimensional array of circular through-apertures, the method comprising: selecting a square array of positions on a membrane; and selecting a position for an aperture proximate to each one of the square array of positions but offset therefrom; wherein selecting the position for an aperture comprises generating a first random or pseudo-random number $N_x$ between $\pm |x_{max}|$ and a second random or pseudo-random number $N_y$ between $\pm |y_{max}|$ and wherein the position of the aperture is selected such that a centre of the aperture is offset from the proximate position in the square array by a distance of $N_x$ parallel to a first one of the axes of the square array and by a distance of $N_y$ parallel to a first one of the axes of the square array.

27. A diffraction grating designed according to the method of any one of clauses 23 to 26.

28. A measurement system for determining an aberration map for a projection system, the measurement system comprising: a patterning device; an illumination system arranged to illuminate the patterning device with radiation, the patterning device comprising a first patterned region arranged to receive a radiation beam and to form a plurality of first diffraction beams, the first diffraction beams being separated in a shearing direction; a sensor apparatus comprising a second patterned region, the second patterned region comprising a two-dimensional diffraction grating according to any one of clauses 1 to 22 or clause 27, and a radiation detector; the projection system being configured to project the first diffraction beams onto the sensor apparatus, the second patterned region being arranged to receive the first diffraction beams from the projection system and to form a plurality of second diffraction beams from each of the first diffraction beams; a positioning apparatus configured to move at least one of the patterning device and the sensor apparatus in the shearing direction; and a controller configured to: control the positioning apparatus so as to move at least one of the first patterning device and the sensor apparatus in the shearing direction such that an intensity of radiation received by each part of the radiation detector varies as a function of the movement in the shearing direction so as to form an oscillating signal; determine from the radiation detector a phase of a harmonic of the oscillating signal at a plurality of positions on the radiation detector; and determine a set of coefficients that characterize the aberration map of the projection system from the phase of a harmonic of the oscillating signal at the plurality of positions on the radiation detector.

29. A lithographic apparatus comprising the measurement system of clause 28.

**Claims**

1. A diffraction grating for a phase-stepping measurement system for determining an aberration map for a projection system, the diffraction grating comprising a substrate provided with a two-dimensional array of circular through-apertures, wherein a ratio of the radius of the circular apertures to the distance between the centres of adjacent apertures is between 0.34 and 0.38.

2. The diffraction grating of claim 1 wherein the ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

3. The diffraction grating of any preceding claim wherein the ratio of the radius of the circular apertures to the distance between the centres of adjacent apertures is close to an optimum value that results in a minimization of the variation in an interference beam map in a central region in a measurement plane;
   wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and
   wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

4. A diffraction grating for a phase-stepping measurement system for determining an aberration map for a projection system, the diffraction grating comprising a substrate provided with a two-dimensional array of circular through-apertures,
   wherein a ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

5. A diffraction grating for a phase-stepping measurement system for determining an aberration map for a projection system, the diffraction grating comprising a substrate provided with a two-dimensional array of circular through-apertures,

wherein a ratio of the radius of the circular apertures to the distance between the centres of adjacent apertures is close to an optimum value that results in a minimization of the variation in an interference beam map in a central region in a measurement plane;

wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and

wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

6. A diffraction grating for a phase-stepping measurement system for determining an aberration map for a projection system, the diffraction grating comprising a substrate provided with a two-dimensional array of circular through-apertures,

wherein the circular through-apertures are distributed such that a distance between the centres of adjacent apertures is non-uniform and varies across the diffraction grating.

7. The diffraction grating of claim 6 wherein the variation in the distance between the centres of adjacent apertures across the diffraction grating is random or pseudo-random.

8. The diffraction grating of claim 6 or claim 7 wherein the variation in the distance between the centres of adjacent apertures across the diffraction grating is between a nominal distance $\pm$ less than 10 %.

9. The diffraction grating of any one of claims 6 to 8, wherein a ratio of the radius of the circular apertures to the distance between the centres of adjacent apertures is between 0.34 and 0.38.

10. The diffraction grating of any one of claims 6 to 9 wherein the ratio of the radius of the circular apertures to the distance between the centres of adjacent apertures is close to an optimum value that results in a minimization of the gain and cross-talk errors when the diffraction grating is used as a wafer level patterning device of a phase-stepping measurement system for determining an aberration map for a projection system in combination with a reticle level patterning device that comprises a one-dimensional diffraction grating with a 50% duty cycle wherein a reconstruction algorithm of the phase-stepping measurement system assumes that the grating is of the form of a checkerboard grating.

11. The diffraction grating of any one of claims 6 to 10 wherein a ratio of the radius of the circular apertures to the distance between the centres of adjacent apertures is close to an optimum value that results in a minimization of the variation in an interference beam map in a central region in a measurement plane;

wherein a value of the interference beam map at a given position in the measurement plane is given by an amplitude of the first harmonic of the oscillating phase-stepping signal that would result when the diffraction grating is used as a wafer level patterning device of a phase-stepping measurement system for determining an aberration map for a projection system in combination with a reticle level patterning device that comprises a one-dimensional diffraction grating with a 50% duty cycle for zero aberrations; and

wherein the central region in the measurement plane corresponds to an overlap between first and second diffraction beams that result from the $0^{th}$ order diffraction beam from the reticle level patterning device illuminating the diffraction grating, the first diffraction beam being the $+1^{st}$ order diffraction beam in a shearing direction and the $0^{th}$ order diffraction beam in a non-shearing direction and the second diffraction beam being the $-1^{st}$ order diffraction beam in a shearing direction and the $0^{th}$ order diffraction beam in a non-shearing direction.

12. A method of designing a diffraction grating for a phase-stepping measurement system for determining an aberration map for a projection system, the diffraction grating comprising a substrate provided with a two-dimensional array of circular through-apertures, the method comprising:

selecting a value of a ratio of the radius of the circular apertures to the distance between the centres of adjacent apertures that substantially minimises errors in a reconstruction of the aberration map.

**13.** A method of designing a diffraction grating for a phase-stepping measurement system for determining an aberration map for a projection system, the diffraction grating comprising a substrate provided with a two-dimensional array of circular through-apertures, the method comprising:

selecting a square array of positions on a membrane; and
selecting a position for an aperture proximate to each one of the square array of positions but offset therefrom; wherein selecting the position for an aperture comprises generating a first random or pseudo-random number $N_x$ between $\pm|x_{max}|$ and a second random or pseudo-random number $N_y$ between $\pm|y_{max}|$ and wherein the position of the aperture is selected such that a centre of the aperture is offset from the proximate position in the square array by a distance of $N_x$ parallel to a first one of the axes of the square array and by a distance of $N_y$ parallel to a first one of the axes of the square array.

**14.** A measurement system for determining an aberration map for a projection system, the measurement system comprising:

a patterning device;
an illumination system arranged to illuminate the patterning device with radiation, the patterning device comprising a first patterned region arranged to receive a radiation beam and to form a plurality of first diffraction beams, the first diffraction beams being separated in a shearing direction;
a sensor apparatus comprising a second patterned region, the second patterned region comprising a two-dimensional diffraction grating according to any one of claims 1 to 11, and a radiation detector;
the projection system being configured to project the first diffraction beams onto the sensor apparatus, the second patterned region being arranged to receive the first diffraction beams from the projection system and to form a plurality of second diffraction beams from each of the first diffraction beams;
a positioning apparatus configured to move at least one of the patterning device and the sensor apparatus in the shearing direction; and
a controller configured to:

control the positioning apparatus so as to move at least one of the first patterning device and the sensor apparatus in the shearing direction such that an intensity of radiation received by each part of the radiation detector varies as a function of the movement in the shearing direction so as to form an oscillating signal;
determine from the radiation detector a phase of a harmonic of the oscillating signal at a plurality of positions on the radiation detector; and
determine a set of coefficients that characterize the aberration map of the projection system from the phase of a harmonic of the oscillating signal at the plurality of positions on the radiation detector.

**15.** A lithographic apparatus comprising the measurement system of claim 14.

**FIG. 1**

**FIG. 2**

MA'

15a    15b    15c

15a'  15a"    15b'  15b"    15c'  15c"

y

v    u

z    x

**FIG. 3A**

21

19a    19b    19c

y

z    x

**FIG. 3B**

30

31

MA'

36

35

33

34

IL

PS

37

21

32

38

39

z

u

v

23

**FIG. 4**

FIG. 5A

FIG. 5B

FIG. 5C

FIG. 6A

FIG. 6B

FIG. 6C

FIG. 7A

FIG. 7B

FIG. 7C

FIG. 8A

FIG. 8B

FIG. 8C

FIG. 9A

FIG. 9B

FIG. 9C

FIG. 10A

FIG. 10B

FIG. 10C

**FIG. 11A**

**FIG. 11B**

**FIG. 12**

FIG. 13A

FIG. 13B

FIG. 13C

FIG. 14A

FIG. 14B

2D CB pitch=255nm

FIG. 15A

2D PA pitch=255nm

FIG. 15B

2D CB pitch=1414nm

FIG. 15C

2D PA pitch=1414nm

FIG. 15D

FIG. 16A

FIG. 16B

FIG. 16C

FIG. 16D

FIG. 17A
D=D_{nom}

FIG. 17B
D=0.86*D_{nom}

FIG. 17C
D=0.84*D_{nom}

FIG. 17D

FIG. 17E

FIG. 17F

D=0.92*D_{nom}

D=0.90*D_{nom}

D=0.88*D_{nom}

**FIG. 18**

Gain error

gain error (%)

$Z_c$

Gain error

gain error (%)

$Z_c$

$D_{nom}$
$0.92*D_{nom}$
$0.90*D_{nom}$
$0.88*D_{nom}$
$0.86*D_{nom}$
$0.84*D_{nom}$

FIG. 20A

FIG. 20B

FIG. 20C

FIG. 20D

FIG. 20E

FIG. 21A

FIG. 21B

FIG. 22

FIG. 23A

U=0.1*pitch

FIG. 23B

U=0.2*pitch

FIG. 23C

U=0.3*pitch

FIG. 23D

U=0.2*pitch D=0.9*D$_{nom}$

FIG. 24A

$D=D_{nom}$

FIG. 24B

$D=0.9*D_{nom}$

FIG. 24C

$D=0.9*D_{nom}$   $U=0.1*pitch$

FIG. 24D

$D=0.9*D_{nom}$   $U=0.2*pitch$

Europäisches
Patentamt

European
Patent Office

Office européen
des brevets

# EUROPEAN SEARCH REPORT

Application Number

EP 21 17 6240

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2009/082224 A1 (ASML NETHERLANDS BV [NL]; KRUIZINGA BORGERT [NL] ET AL.) 2 July 2009 (2009-07-02) * paragraph [0008] – paragraph [0018] * * paragraph [0070] – paragraph [0072] * * paragraph [0087] – paragraph [0099]; figures 1-15 * | 1-5,12, 14,15 | INV. G02B5/18 G03F7/20 |
| Y | US 2001/019407 A1 (SATO KAZUYA [JP] ET AL) 6 September 2001 (2001-09-06) * paragraph [0071] – paragraph [0077] * * paragraph [0106] – paragraph [0134]; figures 1-22 * | 1-5,12, 14,15 | |
| Y | US 6 317 198 B1 (SATO KAZUYA [JP] ET AL) 13 November 2001 (2001-11-13) * column 3, line 8 – column 4, line 32 * * column 9, line 57 – column 12, line 55; figures 1-14 * | 1-5,12, 14,15 | |
| Y | WO 2019/149467 A1 (ASML NETHERLANDS BV [NL]) 8 August 2019 (2019-08-08) * paragraph [0007] – paragraph [00062] * * paragraph [000159] – paragraph [000162]; figures 1-21 * | 1,12,14, 15 | TECHNICAL FIELDS SEARCHED (IPC) G02B G03F G01M |

The present search report has been drawn up for all claims

| Place of search | Date of completion of the search | Examiner |
|---|---|---|
| Munich | 9 November 2021 | Frisch, Anna Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

**EP 21 17 6240**

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-5, 12, 14, 15

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

# LACK OF UNITY OF INVENTION
## SHEET B

**Application Number**

**EP 21 17 6240**

The Search Division considers that the present European patent application does not comply with the requirements of unity of invention and relates to several inventions or groups of inventions, namely:

**1. claims: 1-5, 12, 14, 15**

> Subject 1 relates to a substrate with a periodic array of apertures used in an exposure apparatus where the ratio of aperture ratio and aperture distance is optimised, to a corresponding method of design, and to a measurement system and an exposure apparatus using it.
> ---

**2. claims: 6-11, 13**

> Subject 2 relates to a substrate with a non-periodic array of apertures used in an exposure apparatus where the random aperture distances are optimised, and to a corresponding method of design.
> ---

## ANNEX TO THE EUROPEAN SEARCH REPORT
## ON EUROPEAN PATENT APPLICATION NO.

EP 21 17 6240

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2021

| Patent document cited in search report | | Publication date | Patent family member(s) | | Publication date |
|---|---|---|---|---|---|
| WO 2009082224 | A1 | 02-07-2009 | CN | 101903808 A | 01-12-2010 |
| | | | JP | 5401470 B2 | 29-01-2014 |
| | | | JP | 2011510480 A | 31-03-2011 |
| | | | KR | 20100099743 A | 13-09-2010 |
| | | | US | 2010284064 A1 | 11-11-2010 |
| | | | WO | 2009082224 A1 | 02-07-2009 |
| US 2001019407 | A1 | 06-09-2001 | JP | 3302965 B2 | 15-07-2002 |
| | | | JP | 2001230179 A | 24-08-2001 |
| | | | US | 2001019407 A1 | 06-09-2001 |
| | | | US | 2004180278 A1 | 16-09-2004 |
| US 6317198 | B1 | 13-11-2001 | JP | 3302926 B2 | 15-07-2002 |
| | | | JP | 2000021732 A | 21-01-2000 |
| | | | US | 6317198 B1 | 13-11-2001 |
| WO 2019149467 | A1 | 08-08-2019 | CN | 111670351 A | 15-09-2020 |
| | | | JP | 2021513096 A | 20-05-2021 |
| | | | KR | 20200111259 A | 28-09-2020 |
| | | | NL | 2021357 A | 16-08-2018 |
| | | | TW | 201935088 A | 01-09-2019 |
| | | | US | 2020363573 A1 | 19-11-2020 |
| | | | WO | 2019149467 A1 | 08-08-2019 |

EPO FORM P0459

For more details about this annex : see Official Journal of the European Patent Office, No. 12/82